(19) Europäisches Patentamt
European Patent Office
Office européen des brevets

(11) **EP 4 228 048 A1**

(12) **EUROPEAN PATENT APPLICATION**
published in accordance with Art. 153(4) EPC

(43) Date of publication:
**16.08.2023 Bulletin 2023/33**

(21) Application number: **21944453.6**

(22) Date of filing: **10.12.2021**

(51) International Patent Classification (IPC):
***H01M 10/0585*** (2010.01)

(86) International application number:
**PCT/CN2021/137152**

(87) International publication number:
**WO 2023/102909 (15.06.2023 Gazette 2023/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Contemporary Amperex Technology Co., Limited**
**Ningde, Fujian 352100 (CN)**

(72) Inventors:
• **LI, Mingling**
**Ningde, Fujian 352100 (CN)**

• **PENG, Jia**
**Ningde, Fujian 352100 (CN)**
• **LIU, Xin**
**Ningde, Fujian 352100 (CN)**
• **HUANG, Qisen**
**Ningde, Fujian 352100 (CN)**
• **LI, Cheng**
**Ningde, Fujian 352100 (CN)**
• **LIU, Xianghui**
**Ningde, Fujian 352100 (CN)**

(74) Representative: **Rowlands, Stuart Michael et al**
**Maucher Jenkins**
**Seventh Floor Offices**
**Artillery House**
**11-19 Artillery Row**
**London SW1P 1RT (GB)**

(54) **BATTERY CELL, BATTERY SET, BATTERY PACK, AND ELECTRICAL DEVICE**

(57) The present application relates to a battery cell, a battery module, a battery pack, and an electrical apparatus. The battery cell includes an intermediate portion and side portions located on two sides of the intermediate portion in a thickness direction, the intermediate portion comprising m battery cell sub-units and the side portions comprising n battery cell sub-units, where m+n is an integer greater than or equal to 3. Each of the battery cell sub-units comprises a positive electrode sheet, a negative electrode sheet and a separator arranged between the positive electrode sheet and the negative electrode sheet, and each of the m battery cell sub-units has a dry battery cell nail penetration short-circuit resistance greater than that of each of the n battery cell sub-units.

**FIG. 1**

EP 4 228 048 A1

**Description**

**Technical Field**

The present application relates to the technical field of energy storage devices, and in particular to a battery cell, a battery module, a battery pack, and an electrical apparatus.

**Background Art**

Secondary batteries have the advantages of small size, high energy density, high power density, many cycles of use and long storage time, and are widely used in some electronic devices, electric vehicles, electric toys and electric devices, such as mobile phones, laptops, electric motorcycles, electric vehicles, electric planes, electric ships, electric toy cars, electric toy ships, electric toy planes and electric tools. The secondary batteries are used as driving power sources for new energy vehicles or large-capacity storage units in energy storage power stations. Usually, a plurality of individual cells need to be connected in series or in parallel to obtain battery modules or battery packs with a higher volumetric energy density.

As the secondary batteries have higher and higher requirements for energy density improvement, the produced battery cells tend to become larger and thicker. Thick battery cells can increase space utilization when forming a battery module, so that the energy density of the battery module and the battery pack can be improved. However, thick battery cells also have some disadvantages compared to thin battery cells. For example, for a needle penetration test, since the thick battery cells have more short-circuit contact points, it is more difficult for the thick battery cells to pass the needle penetration test than the thin battery cells.

In the prior art, various studies have been conducted to improve the overall safety performance of the thick battery cells. For example, some literature propose improving the safety performance of the battery cell by uniformly designing the interior of the thick battery cell, such as by changing a separator in the battery cell, the material of a current collector, etc., so as to make it easier to pass the needle penetration test.

**Summary of the Invention**

However, in the prior art, the uniform design of the interior of the thick battery cell can improve the overall safety of the battery cell, but will also lead to a decrease in the overall performance of the battery cell. For example, the energy density, the rate performance and the cycling performance of the battery cell will be reduced. In addition, in the prior art, the internal structure of the battery cell is not analyzed and improved, and the safety of the battery cell and the performance, such as the energy density, the rate performance and cycling performance of the battery cell cannot be taken into account at the same time.

The present application is made in view of the above problems in the prior art. An objective of the present application is to provide a battery cell including a battery cell sub-unit of an intermediate portion and battery cell sub-units of side portions located on two sides of the intermediate portion in a thickness direction. Each battery cell sub-unit of the intermediate portion has a dry battery cell nail penetration short-circuit resistance greater than that of each of the battery cell sub-units of the side portions, so that the battery cell sub-units in the side portions make up for the performance loss of the intermediate portion, so as to improve the safety of the battery cell without reducing the performance of the battery cell such as the energy density and the rate performance.

A first aspect of the present application provides a battery cell, including an intermediate portion and side portions located on two sides of the intermediate portion in a thickness direction, the intermediate portion including $m$ battery cell sub-units and the side portions including $n$ battery cell sub-units, $m+n$ being an integer greater than or equal to 3, wherein each of the battery cell sub-units includes a positive electrode sheet, a negative electrode sheet and a separator arranged between the positive electrode sheet and the negative electrode sheet, and each of the $m$ battery cell sub-units has a dry battery cell nail penetration short-circuit resistance greater than that of each of the $n$ battery cell sub-units.

Optionally, the intermediate portion has a thickness accounting for 20% to 40% of the total thickness of the battery cell.

Optionally, the positive electrode sheet includes a positive electrode current collector, the positive electrode current collector including a support layer and a metal layer, and the support layer of the positive electrode current collector of each of the $m$ battery cell sub-units has a thickness greater than that of the support layer of the positive electrode current collector of each of the $n$ battery cell sub-units.

Optionally, the metal layer of the positive electrode current collector of each of the $m$ battery cell sub-units has a resistivity greater than that of the metal layer of the positive electrode current collector of each of the $n$ battery cell sub-units. Optionally, the resistivity of the metal layer of the positive electrode current collector of each of the $m$ battery cell sub-units is 1.05 to 1.5 times the resistivity of the metal layer of the positive electrode current collector of each of the n battery cell sub-units.

Optionally, the metal layer of the positive electrode current collector of each of the m battery cell sub-units has a thickness smaller than that of the metal layer of the positive electrode current collector of each of the n battery cell sub-units. Optionally, the thickness of the metal layer of the positive electrode current collector of each of the m battery cell sub-units is 60% to 90% of the thickness of the metal layer of the positive electrode current collector of each of the n battery cell sub-units.

Optionally, the positive electrode sheet of each of the m battery cell sub-units has a coating weight smaller than that of the positive electrode sheet of each of the n battery cell sub-units, optionally, the coating weight of the positive electrode sheet of each of the m battery cell sub-units is 70% to 90% of the coating weight of the positive electrode sheet of each of the n battery cell sub-units; and/or the negative electrode sheet of each of the m battery cell sub-units has a coating weight smaller than that of the negative electrode sheet of each of the n battery cell sub-units, optionally, the coating weight of the negative electrode sheet of each of the m battery cell sub-units is 70% to 90% of the coating weight of the negative electrode sheet of each of the n battery cell sub-units.

Optionally, a binder in the positive electrode sheet of each of the m battery cell sub-units has a content greater than that of a binder in the positive electrode sheet of each of the n battery cell sub-units, optionally, the content of the binder in the positive electrode sheet of each of the m battery cell sub-units is 3% by weight to 4% by weight, and the content of the binder in the positive electrode sheet of each of the n battery cell sub-units is 1% by weight to 2% by weight; and/or a binder in the negative electrode sheet of each of the m battery cell sub-units has a content greater than that of a binder in the negative electrode sheet of each of the n battery cell sub-units, optionally, the content of the binder in the negative electrode sheet of each of the m battery cell sub-units is 3% by weight to 4% by weight, and the content of the binder in the negative electrode sheet of each of the n battery cell sub-units is 1% by weight to 2% by weight.

Optionally, the positive electrode sheet of each of the m battery cell sub-units has a compaction density smaller than that of the positive electrode sheet of each of the n battery cell sub-units, optionally, the compaction density of the positive electrode sheet of each of the m battery cell sub-units is 80% to 98% of the compaction density of the positive electrode sheet of each of the n battery cell sub-units; and/or the negative electrode sheet of each of the m battery cell sub-units has a compaction density smaller than that of the negative electrode sheet of each of the n battery cell sub-units, optionally, the compaction density of the negative electrode sheet of each of the m battery cell sub-units is 80% to 98% of the compaction density of the negative electrode sheet of each of the n battery cell sub-units.

Optionally, the separator of each of the m battery cell sub-units has a thickness greater than that of the separator of each of the n battery cell sub-units. Optionally, the thickness of the separator of each of the m battery cell sub-units is 10 to 13 $\mu$m, and the thickness of the separator of each of the n battery cell sub-units is 7 to 9 $\mu$m.

Optionally, the total thickness of the battery cell and the total number m+n of the battery cell sub-units satisfy: the total thickness of the battery cell/(m+n) ≥ 5 mm.

Optionally, the battery cell is constituted by an alternate arrangement of A battery cell sub-units and B battery cell sub-units, the A battery cell sub-unit and the B battery cell sub-unit contain a silicon-based material as a negative electrode active material, the content of the silicon-based material of the A battery cell sub-unit is 10% by weight or more, and the content of the silicon-based material of the B battery cell sub-unit is less than 10% by weight.

Optionally, a binder in the A battery cell sub-unit has an elastic modulus greater than that of a binder in the B battery cell sub-unit.

Optionally, the A battery cell sub-unit is a wound battery cell, and the A battery cell sub-unit has a thickness smaller than that of the B battery cell sub-unit.

A second aspect of the present application provides a battery module including the battery cell of the first aspect described above.

A third aspect of the present application provides a battery pack including the battery module of the second aspect described above.

A fourth aspect of the present application provides an electrical apparatus including the battery module of the second aspect described above, or the battery pack of the third aspect described above, wherein the battery module or the battery pack is used as a power source or an energy storage unit of the electrical apparatus.

[Technical Effects]

In the present application, the battery cell is configured to include battery cell sub-units of an intermediate portion and battery cell sub-units of side portions located on two sides of the intermediate portion in a thickness direction, and each of the battery cell sub-units of the intermediate portion has a dry battery cell nail penetration short-circuit resistance greater than that of each of the battery cell sub-units of the side portions, such that the battery cell sub-units in the intermediate portion adopt a design that is easy to pass a nail penetration test, and the battery cell sub-units of the side portions adopt a design that focuses on maintaining the energy density, the rate performance, etc., so that compared with the uniform design of the entire battery cell, the safety of the battery cell can be improved without reducing the energy density, the rate performance, etc. of the battery cell.

In addition, in the present application, the battery cell is configured in such a way that the A battery cell sub-units with a negative electrode sheet having a large cyclic expansion force and the B battery cell sub-units with a negative electrode sheet having a small cyclic expansion force are alternately arranged, so that it is possible to offset the influence of the cyclic expansion forces generated in both the A battery cell sub-units and the B battery cell sub-units, and to prevent breaking, wrinkling and other problems of the negative electrode sheet of an inner ring, and the performance of the battery cell such as the energy density, the rate performance and the cycling performance can thus be improved while reducing the overall cyclic expansion force and improving the safety of the battery cell.

## Description of Drawings

Fig. 1 is a cross-sectional schematic diagram showing an example of the internal structure of a battery cell of the present application.

Figs. 2A to 2C are schematic diagrams for explaining the mechanism that the short-circuit of an intermediate portion of a thick battery cell is more serious than that of side portions on two sides of the intermediate portion.

Fig. 3A is a schematic diagram for explaining a state in which nail penetration is performed in the case where five identical battery cell sub-units are arranged in an overlapping manner and fixed.

Fig. 3B is a schematic diagram of a positive-negative resistance of each of battery cell sub-units after nail penetration is performed in the case where five identical battery cell sub-units are arranged in an overlapping manner and fixed.

Fig. 4A is a schematic diagram showing a battery cell of the present application in which A battery cell sub-units and B battery cell sub-units are alternately arranged to form a wound battery cell.

Fig. 4B is a schematic diagram showing a battery cell of the present application in which A battery cell sub-units and B battery cell sub-units are alternately arranged to form a laminated battery cell.

Fig. 5A is a schematic diagram showing an example of a battery cell of the present application.

Fig. 5B is an exploded view showing an example of the battery cell of the present application shown in Fig. 5A.

Fig. 6 is a schematic diagram showing an example of a battery module of the present application.

Fig. 7A is a schematic diagram showing an example of a battery pack of the present application.

Fig. 7B is an exploded view showing an example of the battery pack of the present application shown in Fig. 7A.

Fig. 8 is a schematic diagram showing an example of an electrical apparatus using a battery module of the present application as a power source.

Description of reference signs

5, 5a, 5b Battery cell
51 Case
52 Electrode assembly
53 Cover plate
4 Battery module
1 Battery pack
2 Upper box
3 Lower box
10, 30 Battery cell sub-unit of side portion
20 Battery cell sub-unit of intermediate portion
102, 302 Separator of battery cell sub-unit of side portion
202 Separator of battery cell sub-unit of intermediate portion
101, 301 Positive electrode sheet of battery cell sub-unit of side portion
201 Positive electrode sheet of battery cell sub-unit of intermediate portion
103, 303 Negative electrode sheet of battery cell sub-unit of side portion
203 Negative electrode sheet of battery cell sub-unit of intermediate portion
101a, 101e, 301a, 301e Active material layer of positive electrode sheet of battery cell sub-unit of side portion
201a, 201e Active material layer of positive electrode sheet of battery cell sub-unit of intermediate portion
101b, 101d, 301b, 301d Metal layer of positive electrode sheet of battery cell sub-unit of side portion
201b, 201d Metal layer of positive electrode sheet of battery cell sub-unit of intermediate portion

101c, 301c Support layer of positive electrode sheet of battery cell sub-unit of side portion
201c Support layer of positive electrode sheet of battery cell sub-unit of intermediate portion

**Detailed Description**

By "range" disclosed herein is defined in the form of a lower limit and an upper limit, a given range is defined by selecting a lower limit and an upper limit, and the selected lower and upper limits define the boundaries of the particular range. A range defined in this manner may be inclusive or exclusive of extreme values, and may be arbitrarily combined, that is, any lower limit may be combined with any upper limit to form a range. For example, if ranges of 60-120 and 80-110 are listed for a particular parameter, it is understood that ranges of 60-110 and 80-120 are also contemplated. Additionally, if the minimum range values 1 and 2 are listed, and if the maximum range values 3, 4 and 5 are listed, the following ranges are all contemplated: 1-3, 1-4, 1-5, 2-3, 2-4 and 2-5. In the present application, unless stated otherwise, the numerical range "a-b" represents an abbreviated representation of any combination of real numbers between a and b, where both a and b are real numbers. For example, the numerical range "0-5" means that all real numbers between "0-5" have been listed herein, and "0-5" is just an abbreviated representation of the combination of these numerical values. Additionally, when it is stated that a certain parameter is an integer of $\geq 2$, it is equivalent to disclosing that the parameter is, for example, an integer of 2, 3, 4, 5, 6, 7, 8, 9, 10, 11, 12, etc.

In the present application, unless otherwise specified, all embodiments and preferred embodiments mentioned herein may be combined with each other to form new technical solutions.

In the present application, unless otherwise specified, all steps mentioned herein may be performed sequentially or randomly, but preferably sequentially. For example, the method includes steps (a) and (b), meaning that the method may include steps (a) and (b) performed sequentially, or may include steps (b) and (a) performed sequentially. For example, the reference to the method may further include step (c), meaning that step (c) may be added to the method in any order. For example, the method may include steps (a), (b) and (c), or may include steps (a), (c) and (b), or may include steps (c), (a) and (b), and so on.

In the present application, unless otherwise specified, the terms "comprise", "comprising", "include" and "including" mentioned herein may be inclusive or exclusive. For example, the "including" and "comprising" may indicate that it is possible to include or comprise other components not listed, and it is also possible to include or comprise only the listed components.

In the description herein, it should be noted that, "above" and "below" are inclusive of the numerical numeral itself, and the meaning of "more" in "one or more" is two and more, unless otherwise specified.

In the description herein, unless otherwise stated, the term "or" is inclusive. By way of example, the phrase "A or B" means "A, B, or both A and B." More specifically, the condition "A or B" is satisfied by any one of the following conditions: A is true (or present) and B is false (or absent); A is false (or absent) and B is true (or present); or both A and B are true (or present).

[Battery cell]

In the present application, "battery cell" refers to a battery unit that can be independently charged and discharged. The constituent members of the battery cell may include a positive electrode sheet, a negative electrode sheet, a separator, an electrolyte solution, and an outer package for encapsulating the positive electrode sheet, the negative electrode sheet, the separator and the electrolyte solution. The present application does not have any special restrictions on the type and shape of the battery cells, which may be pouch battery cells, cylindrical battery cells, prismatic battery cells or other types of battery cells. The battery cells in the present application may be lithium-ion battery cells, potassium-ion battery cells, sodium-ion battery cells, lithium-sulfur battery cells, etc., and are particularly preferably lithium-ion battery cells. During the charging and discharging process of the battery, active ions are intercalated and deintercalated back and forth between the positive electrode sheet and the negative electrode sheet. The electrolyte solution serves to conduct ions between the positive electrode sheet and the negative electrode sheet.

In the present application, the "chemical system" of a battery cell is divided according to the composition of the positive electrode active material used in the positive electrode sheet in the battery cell, and the element or substance for doping or coating of the positive electrode active material is not limited. For example, a battery cell whose positive electrode active material is lithium iron phosphate (including those doped with Mn or V element) may be defined as a lithium iron phosphate chemical system battery cell. A battery cell whose positive electrode active material is nickel cobalt lithium manganate (generally referred to as NCM) may be defined as an NCM chemical system battery cell. Further, the chemical system of the battery cell may be further defined according to the relative contents of nickel, cobalt and manganese elements in the positive electrode active material. For example, a battery cell whose positive electrode active material is $LiNi_{0.5}Co_{0.2}Mn_{0.3}O_2$ (generally referred to as NCM523) may be defined as an NCM523 chemical system battery cell, a battery cell whose positive electrode active material is $LiNi_{0.6}Co_{0.2}Mn_{0.2}O_2$ (generally referred to as NCM622) may be defined as an NCM622 chemical system battery cell, and a battery cell whose positive electrode active material is $LiNi_{0.8}Co_{0.1}Mn_{0.1}O_2$ (generally referred to as NCM811) may be defined as an NCM811 chemical system battery cell. A battery cell whose positive electrode active material is lithium nickel cobalt aluminum oxides (generally referred to as NCA) may be defined as an NCA chemical system battery cell. In addition, in the present application, a hybrid system battery cell may also be used, for example, a hybrid system cell including NCM and NCA.

The basic structures of the negative electrode sheet, the positive electrode sheet, the electrolyte solution, and the separator included in the battery cell in the present application will be described first below.

<Negative electrode sheet>

The battery cell of the present application includes a negative electrode sheet, which includes a negative electrode current collector and a negative electrode film layer provided on at least one surface of the negative electrode current collector. The negative electrode film layer includes a negative electrode active material.

In an embodiment of the present application, the negative electrode active material of the negative electrode film layer may include commonly used negative electrode active materials, such as one or more of artificial graphite, natural graphite, soft carbon, hard carbon, a silicon-based material, a tin-based material, and lithium titanate. The silicon-based material may be selected from one or more of elemental silicon, silicon oxide, and silicon-carbon composite. The tin-based material may be selected from one or more of elemental tin, a tin oxygen compound and a tin alloy.

In the battery cell of the present application, the negative electrode film layer includes a negative electrode active material and an optional binder, an optional conductive agent and other optional auxiliaries, and is generally formed by coating a negative electrode slurry and drying. The negative electrode slurry is generally formed by dispersing the negative electrode active material as well as the optional conductive agent and the binder, etc. in a solvent and uniformly stirring. The solvent may be N-methyl pyrrolidone (NMP) or deionized water.

By way of example, the conductive agent may include one or more of superconducting carbon, carbon black (such as acetylene black and Ketjen black), carbon dot, carbon nanotube, graphene, and carbon nanofiber.

By way of example, the binder may include one or more of styrene butadiene rubber (SBR), water-soluble unsaturated resin SR-1B, polyacrylic acid (PAA), sodium polyacrylate (PAAS), polyacrylamide (PAM), polyvinyl alcohol (PVA), sodium alginate (SA) and carboxymethyl chitosan (CMCS). By way of example, the binder may include one or more of styrene butadiene rubber (SBR), polyvinyl alcohol (PVA), sodium alginate (SA), polymethacrylic acid (PMAA) and carboxymethyl chitosan (CMCS). Other optional auxiliaries may include thickeners (e. g., sodium carboxymethyl cellulose (CMC-Na)), PTC thermistor material and the like.

In addition, in the battery cell of the present application, the negative electrode sheet does not exclude other additional functional layers other than the negative electrode film layer. For example, in some embodiments, the negative electrode sheet in the present application may further include a conductive primer coating (e.g., composed of a conductive agent and a binder) sandwiched between the negative electrode current collector and a first negative electrode film layer and arranged on the surface of the negative electrode current collector. In some other embodiments, the negative electrode sheet of the present application may further include a protective cover layer covering the surface of a second negative electrode film layer.

In the battery cell of the present application, the negative electrode current collector may be a metal foil or a composite current collector. For example, the metal foil may be a copper foil, a silver foil, an iron foil, or a foil composed of an alloy of the above metals. The composite current collector may include a polymer material substrate layer and a metal layer formed on at least one surface of the polymer material substrate layer, and may be formed by forming a metal material (copper, copper alloy, nickel, nickel alloy, titanium, titanium alloy, silver and silver alloy, etc.) on a polymer material substrate layer (a substrate layer made of a material such as polypropylene (PP), polyethylene terephthalate (PET), polybutylene terephthalate (PBT), polystyrene (PS), polyethylene (PE), and their copolymers).

<Positive electrode sheet>

In the battery cell of the present application, the positive electrode sheet includes a positive electrode current collector, and a positive electrode film layer arranged on at least one surface of the positive electrode current collector and including a positive electrode active material. For example, the positive electrode current collector has two opposite surfaces in its own thickness direction, and the positive electrode film layer is arranged on either or both of the two opposite surfaces of the positive electrode current collector. In the battery cell of the present application, the positive electrode current collector may be a metal foil or a composite current collector. For example, the metal foil may be an aluminum foil, and the composite current collector may include a polymer material substrate layer and a metal layer formed on at least one surface of the polymer material substrate layer. The composite current collector may be formed by forming a metal material (aluminum, aluminum alloy, nickel, nickel alloy, titanium, titanium alloy, silver and silver alloy, etc.) on a polymer material substrate (e.g., a substrate of polypropylene (PP), polyethylene terephthalate (PET), polybutylene terephthalate (PBT), polystyrene (PS), polyethylene (PE), and their copolymers).

In the battery cell of the present application, the positive electrode active material may be a positive electrode active material for battery cells known in the art. For example, the positive electrode active material may include one or more of a lithium-containing phosphate of an olivine structure, a lithium transition metal oxide, and a modified compound thereof. However, the present application is not limited to these materials, and other conventional materials useful as positive electrode active materials for battery cells can also be used. These positive electrode active materials may be used alone or in combination of two or more thereof. Examples of the lithium transition metal oxide may include, but are not limited to, one or more of a lithium-cobalt oxide (such as $LiCoO_2$), a lithium-nickel oxide (such as $LiNiO_2$), a lithium-manganese oxide (such as $LiMnO_2$, and $LiMn2O_4$), a lithium-nickel-cobalt oxide, a lithiummanganese-cobalt oxide, a lithium-nickel-manganese oxide, a lithium-nickel-cobalt-manganese oxide (such as $LiNi_{1/3}Co_{1/3}Mn_{1/3}O_2$(NCM333), $LiNi_{0.5}Co_{0.2}Mn_{0.3}O_2$(NCM523), $LiNi_{0.5}Co_{0.25}Mn_{0.25}O_2$(NCM211), $LiNi_{0.6}Co_{0.2}Mn_{0.2}O_2$(NCM622), $LiNi_{0.8}Co_{0.1}Mn_{0.1}O_2$(NCM811)), a lithium-nickel-cobalt-aluminum oxide (such as $LiNi_{0.85}Co_{0.15}Al_{0.05}O_2$) and a modified compound thereof. Examples of the lithium-containing phosphate of an olivine structure may include, but are not limited to, one or more of lithium iron phosphate (such as $LiFePO_4$(LFP)), a composite material of lithium iron phosphate and carbon, lithium manganese phosphate (such as $LiMnPO_4$), a composite material of lithium manganese phosphate and carbon, lithium iron manganese phosphate, and a composite material of lithium manganese iron phosphate and carbon.

In some embodiments, the positive electrode film layer further optionally includes a binder. Non-limiting examples of the binder that can be used in the positive electrode film layer may include one or more of polyvinylidene fluoride (PVDF), polytetrafluoroethylene (PTFE), a vinylidene fluoride-tetrafluoroethylene-propylene terpolymer, a vinylidene fluoride-hexafluoropropylene-tetrafluoroethylene terpolymer, a tetrafluoroethylene-hexafluoropropylene copolymer and a fluorine-containing acrylate resin.

In some embodiments, the positive electrode film layer may further optionally include a conductive agent. Examples of the conductive agent for the positive electrode film layer may include one or more of superconducting carbon, acetylene black, carbon black, Ketjen black, carbon dot, carbon nanotube, graphene, and carbon nanofiber.

In an embodiment of the present application, the positive electrode sheet may be prepared by dispersing the components for preparing the positive electrode sheet, for example, the positive electrode active material, the conductive agent, the binder and any other components in a solvent (for example, N-methyl pyrrolidone ) to form a uniform positive electrode slurry; and applying the positive electrode slurry on a positive electrode current collector, followed by oven drying, cold pressing and other procedures, to obtain the positive electrode sheet.

<Electrolyte solution>

The electrolyte solution serves to conduct ions between the positive electrode sheet and the negative electrode sheet. The electrolyte solution comprises an electrolyte salt and a solvent. In some embodiments, the electrolyte salt may be selected from one or more of lithium hexafluorophosphate ($LiPF_6$), lithium tetrafluoroborate ($LiBF_4$), lithium perchlorate ($LiClO_4$), lithium hexafluoroarsenate ($LiAsF_6$), lithium bis(fluorosulfonyl)imide (LiFSI), lithium bis(trifluoromethanesulfonyl)imide (LiTFSI), lithium trifluoromethanesulfonate (LiTFS), lithium difluoro(oxalato)borate (LiDFOB), lithium bis(oxalato)borate (LiBOB), lithium difluorophosphate ($LiPO_2F_2$), lithium difluoro bis(oxalato)phosphate (LiDFOP), and lithium tetrafluoro(oxalato)phosphate (LiTFOP).

In an embodiment of the present application, the solvent may be selected from one or more of ethylene carbonate (EC), propylene carbonate (PC), ethyl methyl carbonate (EMC), diethyl carbonate (DEC), dimethyl carbonate (DMC), dipropyl carbonate (DPC), methyl propyl carbonate (MPC), ethyl propyl carbonate (EPC), butylene carbonate (BC), fluoroethylene carbonate (FEC), methyl formate (MF), methyl acetate (MA), ethyl acetate (EA), propyl acetate (PA), methyl propionate (MP), ethyl propionate (EP), propyl propionate (PP), methyl butyrate (MB), ethyl butyrate (EB), 1,4-butyrolactone (GBL), sulfolane (SF), methylsulfonylmethane (MSM), ethyl methyl sulfone (EMS), and ethylsulfonylethane (ESE).

In an embodiment of the present application, based on the total weight of the electrolyte solution, the content of the solvent is 60-99% by weight, for example 65-95% by weight, or 70-90% by weight, or 75-89% by weight, or 80-85% by weight. In an embodiment of the present application, based on the total weight of the electrolyte solution, the content of the electrolyte is 1-40% by weight, for example 5-35% by weight, or 10-30% by weight, or 11-25% by weight, or 15-20% by weight.

In an embodiment of the present application, the electrolyte solution may further optionally include an additive. For example, the additive may include one or more of a negative electrode film-forming additive and a positive electrode film-forming additive, and may further include an additive capable of improving certain performances of the battery, such as an additive for improving the overcharging performance of the battery, an additive for improving the high temperature performance of the battery, an additive for improving the low temperature performance of the battery, etc.

<Separator>

In an embodiment of the present application, the battery cell further includes a separator, which separates the positive side and the negative side of the battery cell, and provides selective permeation or barrier to substances of different types, sizes and charges in the system. For example, the separator can insulate electrons, physically isolate positive and negative electrode active materials of the battery cell, prevent an internal short-circuit and form an electric field in a certain direction, and at the same time enable ions in the battery to move between the positive and negative electrodes through the separator.

In an embodiment of the present application, the material for preparing the separator may include one or more of glass fiber, non-woven cloth, polyethylene, polypropylene, and polyvinylidene fluoride. The separator may be a single-layer film or a multi-layer composite film. When the separator is a multi-layer composite film, the materials of the layers may be the same or different.

In an embodiment of the present application, the positive electrode sheet, the negative electrode sheet, and the separator described above may be made into an electrode assembly/bare battery cell by a winding process or a lamination process.

In an embodiment of the present application, the battery cell may include an outer package which may be used to encapsulate the electrode assembly and the electrolyte solution described above. In some embodiments, the outer package of the battery cell may be a hard case, such as a hard plastic case, an aluminum case, or a steel case. In some other embodiments, the outer package of the battery cell can also be a soft pack, such as a bag-type soft pack. The material of the soft package can be plastic, such as one or more of polypropylene (PP), polybutylene terephthalate (PBT), polybutylene succinate (PBS) and the like.

<Design of the internal structure of a battery cell>

In the present application, the battery cell includes an intermediate portion and side portions located on two sides of the intermediate portion in a thickness direction, the intermediate portion comprising m battery cell sub-units and the side portions comprising n battery cell sub-units, where m+n is an integer greater than or equal to 3. Each of the battery cell sub-units comprises a positive electrode sheet, a negative electrode sheet and a separator arranged between the positive electrode sheet and the negative electrode sheet, and each of the m battery cell sub-units has a dry battery cell nail penetration short-circuit resistance greater than that of each of the n battery cell sub-units.

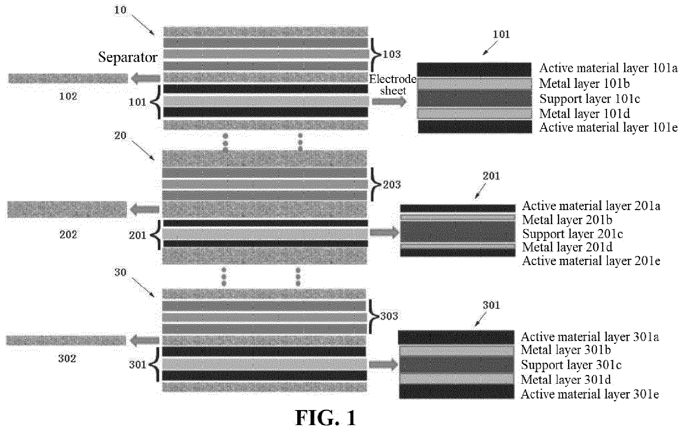

Fig. 1 is a cross-sectional schematic diagram showing an example of the internal structure of a battery cell of the present application.

As shown in Fig. 1, as an example, a thick battery cell in the present application includes, in a thickness direction, a battery cell sub-unit 20 of an intermediate portion, a battery cell sub-unit 10 of an upper side portion located on the upper side of the intermediate portion, and a battery cell sub-unit 30 of a lower side portion located on the lower side of the intermediate portion. Although in the example of Fig. 1, the number of battery cell sub-units of the intermediate portion is one, and the number of battery cell sub-units of the upper side portion and the lower side portion is one, but the numbers are not limited thereto, as long as the sum of the number of battery cell sub-units of the intermediate portion and the numbers of battery cell sub-units of the upper side portion and the lower side portion is an integer greater than or equal to 3. For example, the number of battery cell sub-units of the intermediate portion may also be 2, 3, 4, etc., and the numbers of battery cell sub-units of the upper side portion and the lower side portion may also be 2, 3, 4, etc., respectively; and the number of battery cell sub-units on the upper side does not necessarily need to be the same as the number of battery cell sub-units on the lower side. In addition, the battery cell sub-unit of the intermediate portion is not required to be strictly located in the middle of the thick battery cell, and the battery cell sub-unit of the intermediate portion may also be slightly offset to one of the two sides. In addition, optionally, the proportion of the total thickness of the battery cell sub-units of the intermediate portion to the total thickness of the battery cells may be 20% to 40%. In addition, optionally, the total thickness of the battery cell and the total number m+n of the battery cell sub-units satisfy: the total thickness of the battery cell/(m+n) $\geq$ 5 mm.

In addition, the battery cell sub-unit 20 of the intermediate portion includes a positive electrode sheet 201, a negative electrode sheet 203, and a separator 202 arranged between the positive electrode sheet 201 and the negative electrode sheet 203. The battery cell sub-unit 10 of the upper side portion includes a positive electrode sheet 101, a negative electrode sheet 103, and a separator 102 arranged between the positive electrode sheet 101 and the negative electrode sheet 103. The battery cell sub-unit 30 of the lower side portion includes a positive electrode sheet 301, a negative electrode sheet 303, and a separator 302 arranged between the positive electrode sheet 301 and the negative electrode sheet 303.

In order to describe the possibility of the battery cell sub-unit passing a nail penetration test, the inventors of the present application have customized a parameter named dry battery cell nail penetration short-circuit resistance. The dry battery cell nail penetration short-circuit resistance indicates a positive-negative resistance of a dry battery cell of each battery cell sub-unit after being penetrated by a steel needle of 3 mm, and can be used to describe the degree of short-circuit of the entire dry battery cell after being subjected to nail penetration.

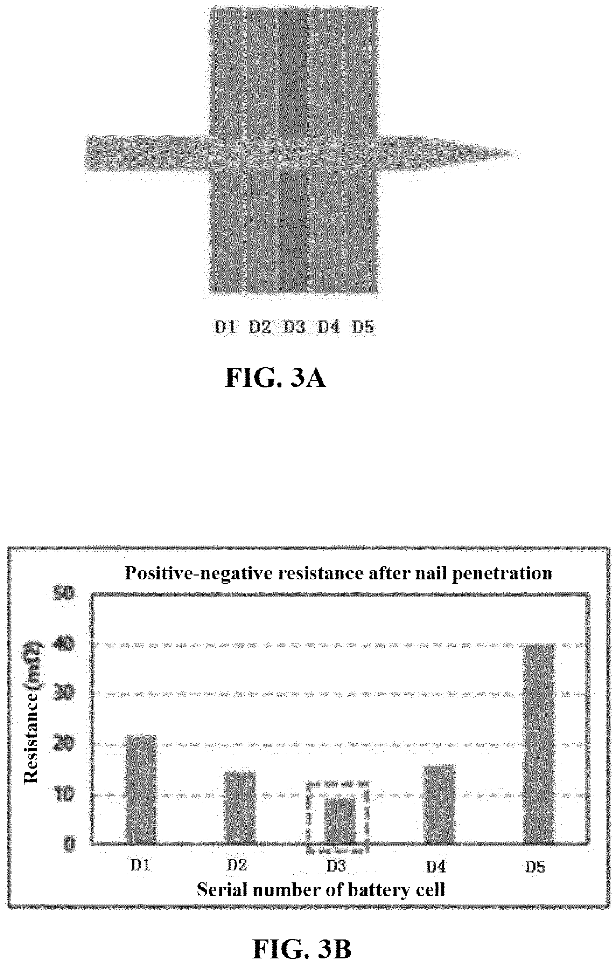

Fig. 3A is a schematic diagram for explaining a state in which nail penetration is performed in the case where five identical battery cell sub-units are arranged in an overlapping manner and fixed. Fig. 3B is a schematic diagram of a positive-negative resistance of each of battery cell sub-units after nail penetration is performed in the case where five identical battery cell sub-units are arranged in an overlapping manner and fixed.

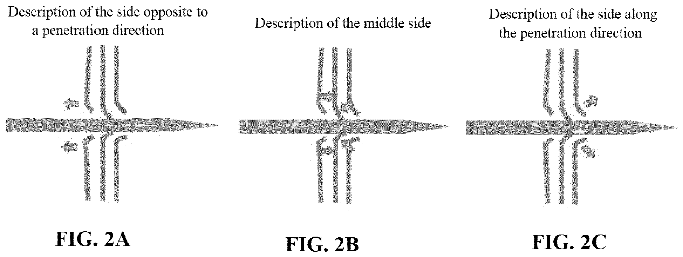

As shown in Figs. 3A and 3B, the inventors of the present application have found that in the case where five identical battery cell sub-units D1, D2, D3, D4, and D5 are arranged in an overlapping manner and fixed, the positive-negative resistance of the battery cell sub-unit D3 located at the intermediate portion is the smallest, and the positive-negative resistances of the battery cell sub-units D1, D2, D4, D5 located at the two side portions gradually increase in directions toward the two sides. In this regard, the inventors of the present application have found the cause and mechanism of the above phenomenon through intensive research, which will be described in detail below with reference to Figs. 2A to 2C.

Figs. 2A to 2C are schematic diagrams for explaining the mechanism that the short-circuit of an intermediate portion of a thick battery cell is more serious than that of side portions on two sides of the intermediate portion.

As shown in Fig. 2B, the battery cell sub-unit of the intermediate portion is subjected to a great restraint (binding force) by the battery cell sub-units on the left and right sides, the stress cannot be released, and the contact with a nail is the closest, resulting in that the short-circuit of the positive and negative electrodes of the battery cell sub-unit of the intermediate portion is the most serious after nail penetration is performed, and the positive-negative resistance is the smallest, so that the possibility of the thick battery cell passing the nail penetration test is greatly reduced.

As shown in Figs. 2A and 2C, the battery cell sub-units of the two side portions are subjected to small restraints (binding forces), and can be expanded freely, and the contact with the nail is reduced, so that the positive-negative resistances of the battery cell sub-units of the two side portions are relatively large.

In order to improve the possibility of the thick battery cell passing the nail penetration test, it can be considered that the dry battery cell nail penetration short-circuit resistance of the battery cell sub-unit of the intermediate portion and the dry battery cell nail penetration short-circuit resistance of the battery cell sub-units of the two side portions are both set larger, but this will seriously affect the overall performance of the thick battery cell such as the energy density and the rate performance.

Therefore, in order to take into account the safety of the battery cell and the performance of the battery cell such as energy density and rate performance at the same time, it is necessary to make the positive-negative resistance of the battery cell sub-unit of the intermediate portion and the positive-negative resistances of the battery cell sub-units of the two side portions more balanced after nail penetration is performed. Therefore, in the present application, the dry battery cell nail penetration short-circuit resistance of the battery cell sub-unit 20 of the intermediate portion is greater than the dry battery cell nail penetration short-circuit resistance of the battery cell sub-units 0, 30 of the two side portions. In addition, it is also possible that at least one of the energy density and the rate performance of the battery cell sub-unit 20 of the intermediate portion is smaller than that of each of the battery cell sub-units 10, 30 of the two side portions.

That is, in the present application, the battery cell sub-unit 20 of the intermediate portion adopts a design that is easier to pass the nail penetration test; while the battery cell sub-units 10, 30 of the two side portions adopt a design with high performance of the battery cell such as the energy density and the rate performance, so that the performance of the battery cell such as the energy density and the rate performance can be improved while improving the safety of the battery cell.

<Design of a positive electrode current collector of a positive electrode sheet of a battery cell sub-unit in a battery cell>

As an example, as shown in Fig. 1, the positive electrode sheet 201 of the battery cell sub-unit 20 of the intermediate portion is composed of a positive electrode current collector 201b-201d, an active material layer 201a arranged on an upper surface of the positive electrode current collector, and an active material layer 201e arranged on a lower surface of the positive electrode current collector. The positive electrode current collector 201b-201d is composed of a support layer 201c, a metal layer 201b arranged on an upper surface of the support layer 201c, and a metal layer 201d arranged on a lower surface of the support layer 201c.

The positive electrode sheet 101 of the battery cell sub-unit 10 of the upper side portion is composed of a positive electrode current collector 101b-101d, an active material layer 101a arranged on an upper surface of the positive electrode current collector, and an active material layer 101e arranged on a lower surface of the positive electrode current collector. The positive electrode current collector 101b-101d is composed of a support layer 101c, a metal layer 101b arranged on an upper surface of the support layer 101c, and a metal layer 101d arranged on a lower surface of the support layer 101c.

The positive electrode sheet 301 of the battery cell sub-unit 30 of the lower side portion is composed of a positive electrode current collector 301b-301d, an active material layer 301a arranged on an upper surface of the positive electrode current collector, and an active material layer 301e arranged on a lower surface of the positive electrode current collector. The positive electrode current collector 301b-301d is composed of a support layer 301c, a metal layer 301b arranged on an upper surface of the support layer 301c, and a metal layer 301d arranged on a lower surface of the support layer 301c.

(Support layer)

In the current collector of the present application, the support layer mainly functions to support and protect the metal layers, and the thickness of the support layer is within a specified range such that neither the volume energy density of the battery using this current collector is reduced, not breakage is likely to occur in an electrode sheet manufacturing process, etc.

The material of the support layer is selected from at least one of an insulating polymer material, an insulating polymer composite material, a conductive polymer material, and a conductive polymer composite material.

The insulating polymer material is selected from at least one of polyamide, polyterephthalate, polyimide, polyethylene, polypropylene, polystyrene, polyvinyl chloride, aramid, polydiformylphenylenediamine, acrylonitrile-butadiene-styrene copolymer, polybutylene terephthalate, poly(p-phenylene terephthalamide), poly(p-phenylene ether), polyoxymethylene, epoxy resin, phenolic resin, polytetrafluoroethylene, polyvinylidene fluoride, silicone rubber, polycarbonate, cellulose and its derivatives, starch and its derivatives, protein and its derivatives, polyvinyl alcohol and its cross-linked products, and polyethylene glycol and its cross-linked products.

The insulating polymer composite material is selected from a composite material formed from an insulating polymer material and an inorganic material. The inorganic material is preferably at least one of a ceramic material (such as silicon oxide, silicon nitride, zirconia, boron nitride, aluminum oxide), a glass material, and a ceramic composite material.

The conductive polymer material is selected from at least one of doped poly(sulfur nitride) and doped polyacetylene.

The conductive polymer composite material is selected from a composite material formed from an insulating polymer material and a conductive material. The conductive material is selected from at least one of a conductive carbon material, a metal material, and a composite conductive material. The conductive carbon material is selected from at least one of carbon black, a carbon nanotube, graphite, acetylene black, and graphene. The metal material is selected from at least one of nickel, iron, copper, aluminum or an alloy of the above metals. The composite conductive material is selected from at least one of nickel-coated graphite powder, and a nickel-coated carbon fiber.

Preferably, the support layer is of an insulating polymer material or an insulating polymer composite material.

Therefore, the short-circuit resistance of the battery when a short-circuit occurs under abnormal conditions can be increased, the short-circuit current can be greatly reduced, and thus the short-circuit heat generation can be greatly reduced, thereby improving the safety performance of the battery.

Preferably, the material of the support layer is selected from organic polymer insulating materials. Since the density of the support layer is generally smaller than that of the metal, the current collector of the present application can increase the weight energy density of the battery while improving the safety performance of the battery. Moreover, since the support layer can play a good role in bearing and protecting the metal layers located on its surfaces, breakage of the electrode sheet is not likely to occur, which is common in traditional current collectors.

(Metal layer)

In the current collector of the present application, the material of the metal layer is selected from at least one of a metal conductive material and a carbon-based conductive material. The metal conductive material is preferably at least one of aluminum, copper, nickel, titanium, silver, a nickel-copper alloy, and an aluminum-zirconium alloy; and the carbon-based conductive material is preferably at least one of graphite, acetylene black, graphene, and a carbon nanotube.

The metal layer may be formed on the support layer by at least one of vapor deposition, electroplating, and electroless plating. The vapor deposition is preferably physical vapor deposition (PVD). The physical vapor deposition is preferably at least one of evaporating and sputtering method. The evaporating is preferably at least one of vacuum evaporating, thermal evaporation deposition, and electron beam evaporation method (EBEM). The sputtering is preferably magnetron sputtering.

(Design of a support layer of a positive electrode current collector of a positive electrode sheet of a battery cell sub-unit)

In the present application, the support layer of the positive electrode current collector of each of the m battery cell sub-units has a thickness greater than that of the support layer of the positive electrode current collector of each of the n battery cell sub-units.

As an example, as shown in Fig. 1, the thickness of the support layer 201c of the positive electrode current collector of the positive electrode sheet 201 of the battery cell sub-unit 20 of the intermediate portion is greater than that of the support layer 101c of the positive electrode current collector of the positive electrode sheet 101 of the battery cell sub-unit 10 of the upper side portion, and greater than that of the support layer 301c of the positive electrode current collector of the positive electrode sheet 301 of the battery cell sub-unit 30 of the lower side portion.

If the thickness of the support layer is thick, it is easy to pass the nail penetration test, and since a metal wire of the metal layer will be wrapped by the support layer, the metal layer is not likely to form sharp burrs, so that the separator is not likely to be penetrated by the metal burrs. However, if the thickness of the support layer is thick, the energy density will be reduced accordingly.

Therefore, in the present application, the positive-negative resistance of the positive electrode current collector of the battery cell sub-unit 20 of the intermediate portion is larger after nail penetration, that is, a design that is easier to pass the nail penetration test is adopted; while the positive electrode current collectors of the battery cell sub-units 10, 30 of the two side portions adopt a design that will not significantly increase the direct-current internal resistance (DCR), that is, the performance of the battery cell such as the energy density is high, so that the performance of the battery cell such as the energy density can be improved while improving the safety of the battery cell.

(Design of a metal layer of a positive electrode current collector of a positive electrode sheet of a battery cell sub-unit)

In the present application, the metal layer of the positive electrode current collector of each of the m battery cell sub-units has a resistivity greater than that of the metal layer of the positive electrode current collector of each of the n battery cell sub-units. Optionally, the resistivity of the metal layer of the positive electrode current collector of each of the m battery cell sub-units is 1.05 to 1.5 times the resistivity of the metal layer of the positive electrode current collector of each of the n battery cell sub-units.

As an example, as shown in Fig. 1, the resistivity of the metal layers 201b, 201d of the positive electrode current collector of the positive electrode sheet 201 of the battery cell sub-unit 20 of the intermediate portion is greater than that of the metal layers 101 of the positive electrode current collector of the positive electrode sheet 101b, 101d of the battery cell sub-unit 10 of the upper side portion, and greater than that of the metal layers 301b, 301d of the positive electrode current collector of the positive electrode sheet 301 of the battery cell sub-unit 30 of the lower side portion. Optionally, the resistivity of the metal layers 201b, 201d of the positive electrode current collector of the positive electrode sheet 201 of the battery cell sub-unit 20 of the intermediate portion is 1.05 to 1.5 times that of the metal layers 101 of the positive electrode current collector of the positive electrode sheet 101b, 101d of the battery cell sub-unit 10 of the upper side portion, and 1.05 to 1.5 times that of the metal layers 301b, 301d of the positive electrode current collector of the positive electrode sheet 301 of the battery cell sub-unit 30 of the lower side portion.

Therefore, in the present application, the positive-negative resistance of the positive electrode current collector of the battery cell sub-unit 20 of the intermediate portion is larger after nail penetration, that is, a design that is easier to pass the nail penetration test is adopted; while the positive electrode current collectors of the battery cell sub-units 10, 30 of the two side portions adopt a design with high performance of the battery cell such as the energy density and the rate performance, so that the performance of the battery cell such as the energy density and the rate performance can be improved while improving the safety of the battery cell.

In addition, in the present application, the metal layer of the positive electrode current collector of each of the m battery cell sub-units has a thickness smaller than that of the metal layer of the positive electrode current collector of each of the n battery cell sub-units. Optionally, the thickness of the metal layer of the positive electrode current collector of each of the m battery cell sub-units is 60% to 90% of the thickness of the metal layer of the positive electrode current collector of each of the n battery cell sub-units.

As an example, as shown in Fig. 1, the thickness of the metal layers 201b, 201d of the positive electrode current collector of the positive electrode sheet 201 of the battery cell sub-unit 20 of the intermediate portion is smaller than that of the metal layers 101 of the positive electrode current collector of the positive electrode sheet 101b, 101d of the battery cell sub-unit 10 of the upper side portion, and smaller than that of the metal layers 301b, 301d of the positive electrode current collector of the positive electrode sheet 301 of the battery cell sub-unit 30 of the lower side portion. Optionally, the thickness of the metal layers 201b, 201d of the positive electrode current collector of the positive electrode sheet 201 of the battery cell sub-unit 20 of the intermediate portion is 60% to 90% of that of the metal layers 101 of the positive electrode current collector of the positive electrode sheet 101b, 101d of the battery cell sub-unit 10 of the upper side portion, and 60% to 90% of that of the metal layers 301b, 301d of the positive electrode current collector of the positive electrode sheet 301 of the battery cell sub-unit 30 of the lower side portion.

Therefore, in the present application, the metal layers of the positive electrode current collector of the battery cell sub-unit 20 of the intermediate portion have a smaller contact area with the nail, that is, a design that is easier to pass the nail penetration test is adopted; while the positive current collectors of the battery cell sub-units 10, 30 of the two side portions adopt a design with high performance of the battery cell such as the energy density and the rate performance, so that the performance of the battery cell such as the energy density and the rate performance can be improved while improving the safety of the battery cell.

<Design of a positive electrode sheet and a negative electrode sheet of a battery cell sub-unit in a battery cell>

(Coating weight of an electrode sheet of a battery cell sub-unit)

In the present application, the positive electrode sheet of each of the m battery cell sub-units has a coating weight smaller than that of the positive electrode sheet of each of the n battery cell sub-units, optionally, the coating weight of the positive electrode sheet of each of the m battery cell sub-units is 70% to 90% of the coating weight of the positive electrode sheet of each of the n battery cell sub-units; and/or the negative electrode sheet of each of the m battery cell sub-units has a coating weight smaller than that of the negative electrode sheet of each of the n battery cell sub-units, optionally, the coating weight of the negative electrode sheet of each of the m battery cell sub-units is 70% to 90% of the coating weight of the negative electrode sheet of each of the n battery cell sub-units.

As an example, as shown in Fig. 1, the coating weight of the positive electrode sheet 201 (the coating weight of the active material layers 201a, 201e) of the battery cell sub-unit 20 of the intermediate portion is smaller than the coating weight of the positive electrode sheet 101 (the coating weight of the active material layers 101a, 101e) of the battery cell sub-unit 10 of the upper side portion, and smaller than the coating weight of the positive electrode sheet 301 (the coating weight of the active material layers 301a, 301e) of the battery cell sub-unit 30 of the lower side portion. Optionally, the coating weight of the positive electrode sheet 201 of the battery cell sub-unit 20 of the intermediate portion is 70% to 90% of the coating weight of the positive electrode sheet 101 of the battery cell sub-unit 10 of the upper side portion, and is 70% to 90% of the coating weight of the positive electrode sheet 301 of the battery cell sub-unit 30 of the lower side portion.

In addition, although not shown, the coating weight of the negative electrode sheet 203 of the battery cell sub-unit 20 of the intermediate portion is smaller than the coating weight of the negative electrode sheet 103 of the battery cell sub-unit 10 of the upper side portion, and smaller than the coating weight of the negative electrode sheet 303 of the battery cell sub-unit 30 of the lower side portion. Optionally, the coating weight of the negative electrode sheet 203 of the battery cell sub-unit 20 of the intermediate portion is 70% to 90% of the coating weight of the negative electrode sheet 103 of the battery cell sub-unit 10 of the upper side portion, and is 70% to 90% of the coating weight of the negative electrode sheet 303 of the battery cell sub-unit 30 of the lower side portion.

Therefore, in the present application, the coating weights of the positive electrode sheet and the negative electrode sheet of the battery cell sub-unit 20 of the intermediate portion is lighter (the active materials are less), and the contact area with the nail is further reduced during nail penetration, that is, the positive electrode sheet and the negative electrode sheet of the battery cell sub-unit 20 of the intermediate portion adopt a design that is easier to pass the nail penetration test; while the positive electrode sheet and the negative electrode sheet of the battery cell sub-units 10, 30 of the two side portions adopt a design with high performance of the battery cell such as the energy density, so that the performance of the battery cell such as the energy density can be improved while improving the safety of the battery cell.

(Content of a binder in an electrode sheet of a battery cell sub-unit)

In the present application, a binder in the positive electrode sheet of each of the m battery cell sub-units has a content greater than that of a binder in the positive electrode sheet of each of the n battery cell sub-units, optionally, the content of the binder in the positive electrode sheet of each of the m battery cell sub-units is 3% by weight to 4% by weight, and the content of the binder in the positive electrode sheet of each of the n battery cell sub-units is 1% by weight to 2% by weight; and/or a binder in the negative electrode sheet of each of the m battery cell sub-units has a content greater than that of a binder in the negative electrode sheet of each of the n battery cell sub-units, optionally, the content of the binder in the negative electrode sheet of each of the m battery cell sub-units is 3% by weight to 4% by weight, and the content of the binder in the negative electrode sheet of each of the n battery cell sub-units is 1% by weight to 2% by weight.

As an example, as shown in Fig. 1, the binder in the positive electrode sheet 201 of the battery cell sub-unit 20 of the intermediate portion has a content greater than that of the binder in the positive electrode sheet 101 of the battery cell sub-unit 10 of the upper side portion, and greater than that of the binder in the positive electrode sheet 301 of the battery cell sub-unit 30 of the lower side portion. Optionally, the content of the binder in the positive electrode sheet 201 of the battery cell sub-unit 20 of the intermediate portion is 3% by weight to 4% by weight, the content of the binder in the positive electrode sheet 101 of the battery cell sub-unit 10 of the upper side portion is 1% by weight to 2% by weight, and the content of the binder in the positive electrode sheet 301 of the battery cell sub-unit 30 of the lower side portion is 1% by weight to 2% by weight.

In addition, although not shown, the binder in the negative electrode sheet 203 of the battery cell sub-unit 20 of the intermediate portion has a content greater than that of the binder in the negative electrode sheet 103 of the battery cell sub-unit 10 of the upper side portion, and greater than the content of the binder in the negative electrode sheet 303 of the battery cell sub-unit 30 of the lower side portion. Optionally, the content of the binder in the negative electrode sheet 203 of the battery cell sub-unit 20 of the intermediate portion is 3% by weight to 4% by weight, the content of the binder in the negative electrode sheet 103 of the battery cell sub-unit 10 of the upper side portion is 1% by weight to 2% by weight, and the content of the binder in the negative electrode sheet 303 of the battery cell sub-unit 30 of the lower side portion is 1% by weight to 2% by weight.

Therefore, in the present application, the content of the binder in the positive electrode sheet and the negative electrode sheet of the battery cell sub-unit 20 of the intermediate portion is relatively high, so that the bonding force of the electrode sheets can be increased, the toughness can be increased, and the active materials are not likely to fall off, that is, the positive electrode sheet and the negative electrode sheet of the battery cell sub-unit 20 of the intermediate portion adopt a design that is not prone to breakage of the electrode sheets; while the positive electrode sheet and the negative electrode sheet of the battery cell sub-units 10, 30 of the two side portions adopt a design with high performance of the battery cell such as the energy density and the rate performance, so that the performance of the battery cell such as the energy density and the rate performance can be improved while improving the safety of the battery cell.

(Compaction density of an electrode sheet of a battery cell sub-unit)

The positive electrode sheet of each of the m battery cell sub-units has a compaction density smaller than that of the positive electrode sheet of each of the n battery cell sub-units, optionally, the compaction density of the positive electrode sheet of each of the m battery cell sub-units is 80% to 98% of the compaction density of the positive electrode sheet of each of the n battery cell sub-units; and/or the negative electrode sheet of each of the m battery cell sub-units has a compaction density smaller than that of the negative electrode sheet of each of the n battery cell sub-units, optionally, the compaction density of the negative electrode sheet of each of the m battery cell sub-units is 80% to 98% of the compaction density of the negative electrode sheet of each of the n battery cell sub-units.

As an example, as shown in Fig. 1, the compaction density of the positive electrode sheet 201 of the battery cell sub-unit 20 of the intermediate portion is smaller than that of the positive electrode sheet 101 of the battery cell sub-unit 10 of the upper side portion, and smaller than that of the positive electrode sheet 301 of the battery cell sub-unit 30 of the lower side portion. Optionally, the compaction density of the positive electrode sheet 201 of the battery cell sub-unit 20 of the intermediate portion is 80% to 98% of the compaction density of the positive electrode sheet 101 of the battery cell sub-unit 10 of the upper side portion, and is 80% to 98% of the compaction density of the positive electrode sheet 301 of the battery cell sub-unit 30 of the lower side portion.

In addition, although not shown, the compaction density of the negative electrode sheet 203 of the battery cell sub-unit 20 of the intermediate portion is smaller than the compaction density of the negative electrode sheet 103 of the battery cell sub-unit 10 of the upper side portion, and smaller than the compaction density of the negative electrode sheet 303 of the battery cell sub-unit 30 of the lower side portion. Optionally, the compaction density of the negative electrode sheet 203 of the battery cell sub-unit 20 of the intermediate portion is 80% to 98% of the compaction density of the negative electrode sheet 103 of the battery cell sub-unit 10 of the upper side portion, and is 80% to 98% of the compaction density of the negative electrode sheet 303 of the battery cell sub-unit 30 of the lower side portion.

Therefore, in the present application, the compaction density of the positive electrode sheet and the negative electrode sheet of the battery cell sub-unit 20 of the intermediate portion is small, so that the contact area between particles of the electrode sheets and the nail can be reduced, and the degree of short-circuit can be reduced during nail penetration, that is, the positive electrode sheet and the negative electrode sheet of the battery cell sub-unit 20 of the intermediate portion adopt a design that is easier to pass the nail penetration test; while the positive electrode sheet and the negative electrode sheet of the battery cell sub-units 10, 30 of the two side portions adopt a design with high performance of the battery cell such as the energy density and the rate performance, so that the performance of the battery cell such as the energy density and the rate performance can be improved while improving the safety of the battery cell.

<Design of a separator of a battery cell sub-unit in a battery cell>

In the present application, the separator of each of the m battery cell sub-units has a thickness greater than that of the separator of each of the n battery cell sub-units. Optionally, the thickness of the separator of each of the m battery cell sub-units is 10 to 13 $\mu$m, and the thickness of the separator of each of the n battery cell sub-units is 7 to 9 $\mu$m.

As an example, as shown in Fig. 1, the thickness of the separator 202 of the battery cell sub-unit 20 of the intermediate portion is greater than that of the separator 102 of the battery cell sub-unit 10 of the upper side portion, and greater than that of the separator 302 of the battery cell sub-unit 30 of the lower side portion. Optionally, the thickness of the separator 202 of the battery cell sub-unit 20 of the intermediate portion is 10 to 13 $\mu$m, the thickness of the separator 102 of the battery cell sub-unit 10 of the upper side portion is 7 to 9 $\mu$m, and the thickness of the separator 302 of the battery cell sub-unit 30 of the lower side portion is 7 to 9 $\mu$m.

If the separator is thick, it is beneficial to block the short-circuit of the positive and negative electrodes, but at the same time, the energy density (capacity) will be reduced. In addition, if the separator is too thick, a transport channel of lithium ions will be longer, which will reduce the rate performance and increase the DCR.

Therefore, in the present application, the thick separator of the battery cell sub-unit 20 of the intermediate portion can achieve a better effect of isolating the short-circuit, that is, the separator of the battery cell sub-unit 20 of the intermediate portion adopts a design that is easier to pass the nail penetration test; while the battery cell sub-units 10, 30 of the two side portions adopt a design with high performance of the battery cell such as the energy density and the rate performance, so that the performance of the battery cell such as the energy density and the rate performance can be improved while improving the safety of the battery cell.

<Design of the alternate arrangement of A battery cell sub-units of a high expansion system and B battery cell sub-units of a low expansion system>

In the present application, the battery cell is constituted by an alternate arrangement of A battery cell sub-units and B battery cell sub-units, the A battery cell sub-unit and the B battery cell sub-unit contain a silicon-based material as a negative electrode active material, the content of the silicon-based material of the A battery cell sub-unit is 10% by weight or more, and the content of the silicon-based material of the B battery cell sub-unit is less than 10% by weight. The silicon-based material is, for example, a silicon-based alloy, silicon oxide, and the like.

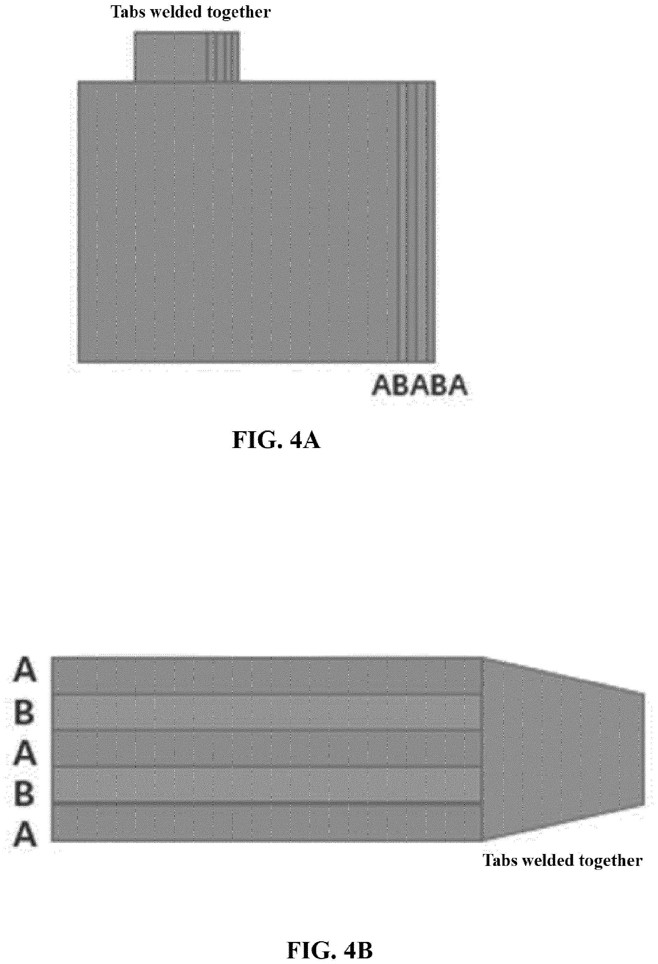

Fig. 4A is a schematic diagram showing a battery cell of the present application in which A battery cell sub-units and B battery cell sub-units are alternately arranged to form a wound battery cell. Fig. 4B is a schematic diagram showing a battery cell of the present application in which A battery cell sub-units and B battery cell sub-units are alternately arranged to form a laminated battery cell.

As an example, as shown in Fig. 4A, the A battery cell sub-units and the B battery cell sub-units are alternately arranged to form a wound battery cell. Here, the wound battery cell refers to a battery cell in which the positive electrode sheet, the negative electrode sheet and the separator are combined in a wound manner. In addition, as another example, as shown in Fig. 4B, the A battery cell sub-units and the B battery cell sub-units are alternately arranged to form a laminated battery cell. Here, the laminated battery cell refers to a battery cell in which the positive electrode sheet, the negative electrode sheet and the separator are combined in a laminated manner.

In the example shown in Figs. 4A and 4B, the content of the silicon-based material in the A battery cell sub-unit is 10% by weight or more, and the content of the silicon-based material in the B battery cell sub-unit is less than 10% by weight.

Therefore, in the present application, by cooperatively using the A battery cell sub-units of the system with a large cyclic expansion force and the B battery cell sub-units of the system with a small cyclic expansion force, the influence of the expansion force can be offset and the overall cyclic expansion force of the battery cell can be reduced.

In addition, in the present application, a binder in the A battery cell sub-unit has an elastic modulus greater than that of a binder in the B battery cell sub-unit.

As an example, as shown in Figs. 4A and 4B, a binder in the A battery cell sub-unit has an elastic modulus greater than that of a binder in the B battery cell sub-unit.

If the elastic modulus of the binder is high, it will lead to a large stress in the electrode sheet, resulting in the fragmentation of active material particles and other problems, which will adversely affect the capacity and the cycling performance. Therefore, in the present application, the elastic modulus of the binder of the A battery cell sub-unit with a higher content of silicon-based material is higher, that is, this adverse effect is concentrated on the A battery cell sub-unit, so that it is possible to improve the performance of the battery cell such as the energy density, the rate performance and the cycling performance while reducing the overall cyclic expansion force and improving the safety of the battery cell.

In addition, in the present application, the A battery cell sub-unit and the B battery cell sub-unit are wound battery cells, and the A battery cell sub-unit has a thickness smaller than that of the B battery cell sub-unit.

As an example, as shown in Fig. 4A, the A battery cell sub-units and the B battery cell sub-units are alternately arranged to form a wound battery cell, and the thickness of the A battery cell sub-unit is smaller than that of the B battery cell sub-unit (not shown).

If the thickness of the battery cell sub-unit is small, the expansion force of the negative electrode can be released to a certain extent in an MD (Machine Direction: longitudinal) direction of the electrode sheet, so that the rupture of the inner ring can be inhibited and the cyclic expansion force can be reduced. Therefore, in the present application, a wound core of the battery cell sub-unit A of the high expansion system has fewer layers and a smaller total thickness, and a wound core of the B battery cell sub-unit of the low expansion system has more layers and a larger total thickness, so that it is possible to improve the performance of the battery cell such as the energy density, the rate performance and the cycling performance while reducing the stress of the inner ring of the wound core, preventing the breakage of the electrode sheet of the inner ring, and improving the safety.

(Method for testing a dry battery cell nail penetration short-circuit resistance)

A wound and hot-pressed dry battery cell is fixed to a fixture, a steel needle of 3 mm is then used to pass through the dry battery cell at a constant speed of 1 mm/s, and the steel needle is stopped after completely penetrating the dry battery cell. Two ports of a resistance meter are respectively connected to positive and negative tabs of the dry battery cell. At this time, the reading of the resistance meter is the nail penetration short-circuit resistance of the dry battery cell.

(Capacity test)

The prepared battery is fully charged at 0.33C at room temperature of 25°C, and then fully discharged, and the discharge capacity is specified as the battery cell capacity.

(Test of the number of cycles at 60°C)

The prepared battery is charged and discharged at 0.33C at room temperature of 25°C, and at the discharge capacity this time is specified as the initial capacity C. The battery is cycled at 60°C with 1C charge and 1C discharge until the capacity decays to 80% of the initial capacity, and the number of cycles corresponding to this time is recorded.

(2C discharge capacity retention rate test)

The prepared battery is fully charged at a rate of 0.33C at room temperature of 25°C, and then discharged, and the discharge capacity at this time is specified as the initial capacity C0. Then, the battery is discharged at a rate of 2C at room temperature of 25°C, and the discharge capacity at this time is specified as C1. The capacity retention rate is calculated according to the following equation:

$$\text{Capacity retention rate} = C1/C0 \times 100\%.$$

(Direct-current discharge internal resistance (DCR) test)

The battery is adjusted to a state of charge (SOC) of 50%, and is discharged at a rate of 4C (with a corresponding discharge current I) for 30 s, and a voltage difference $\Delta V$ before and after the 30 s discharge is recorded. The DCR corresponding to 50% SOC is calculated according to the following equation:

$$DCR = \Delta V/I$$

(Low-speed nail penetration test)

A battery cell is fully charged and then fixed to a fixture. Positive and negative electrodes of the battery are connected to voltage detection lines. Temperature sensing lines are arranged in multiple positions of the battery cell. A high-temperature-resistant steel needle with a diameter of 3 mm passes through the battery cell at a speed of 1 mm/s, standing for 1 hour to record the change in voltage over time. Herein, if there is smoke or fire after nail penetration, or the voltage drop is greater than 0.5 V after standing for 1 hour after nail penetration, it is determined to have failed the nail penetration test; and if there is no smoke or fire after nail penetration, and the voltage drop is less than or equal to 0.5V after standing for 1 hour after nail penetration, it is determined to pass the nail penetration test.

(High-speed nail penetration test)

A battery cell is fully charged and then fixed to a fixture. Positive and negative electrodes of the battery are connected to voltage detection lines. Temperature sensing lines are arranged in multiple positions of the battery cell. A high-temperature-resistant steel needle with a diameter of 3 mm passes through the battery cell at a speed of 80 mm/s, standing for 1 hour to record the change in voltage over time. Herein, if there is smoke or fire after nail penetration, or the voltage drop is greater than 0.5 V after standing for 1 hour after nail penetration, it is determined to have failed the nail penetration test; and if there is no smoke or fire after nail penetration, and the voltage drop is less than or equal to 0.5V after standing for 1 hour after nail penetration, it is determined to pass the nail penetration test.

(Test of the thickness of a metal layer)

JEOL IB-19500 is used to cut the cross-section of the current collector to prepare a cross-section sample, and then the prepared sample is magnified 30,000 times under a scanning electron microscope to measure the thickness of the metal layer.

(Resistivity test)

A sheet resistance R of the current collector is measured by a sheet resistance meter, the thickness d of the metal layer is obtained by the test method using the cross-section and the scanning electron microscope, and the resistivity of the metal layer $\rho$ = R• d.

(Test of compaction density)

In the present application, the compaction density of the electrode sheet may be tested by methods known in the art. As an example, the following method may be used for testing: an electrode sheet that is coated on two sides and cold-pressed is provided, and is punched into a small disc with an area of S 1, the weight of the small disc is measured, which is denoted as M1; the total thickness of the cold-pressed electrode sheet is measured, which is denoted as H; the weight and the thickness of the current collector are pre-measured before coating, which are denoted as M2 and H2, respectively; and the compaction density of the electrode sheet dc = ((M1 - M2)/S1)/(H - H2).

(Test of the thickness of a battery cell sub-unit)

The thickness of the battery cell sub-unit after winding and hot pressing is measured with a micrometer, and the average value is obtained by measuring 5 points.

(Whether an electrode sheet of an inner ring is broken)

A battery cell undergoes cycles of charging at 1C and discharging at 1C at 60°C until the capacity of the battery cell decays to 80% of the initial capacity, the battery cell in this state is disassembled, all the battery cell sub-units are deployed, and all the positive and negative electrode sheets are checked, to see if there is a crack of $\geq$ 5 mm in the innermost ring. As long as the number of cracks is $\geq$ 1, it is determined that there is a breakage, otherwise it is determined that there is no breakage.

(Whether an electrode sheet is wrinkled)

A battery cell undergoes cycles of charging at 1C and discharging at 1C at 60°C until the capacity of the battery cell decays to 80% of the initial capacity, the battery cell in this state is disassembled, all the battery cell sub-units are deployed, and all the positive and anode electrode sheets are checked, to see if there is a wrinkle of $\geq$ 10 mm. As long as the number of wrinkles mentioned above is $\geq$ 1, it is determined that the electrode sheet is wrinkled, otherwise it is determined that the electrode sheet is not wrinkled.

(Test of expansion force at 60°C for 200 cycles)

A battery cell is fixed to a fixture with a force sensor, and then the battery cell is placed at a temperature of 60°C, and after 200 cycles of charging at 1C and discharging at 1C, the expansion force value at this time is read.

<Structure of an outer package of a battery cell>

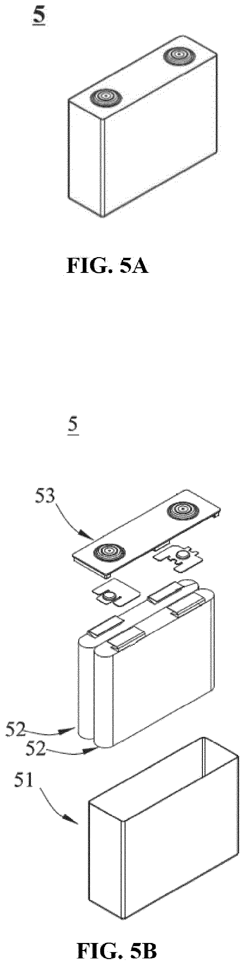

Fig. 5A is a schematic diagram showing an example of a battery cell of the present application. Fig. 5B is an exploded view showing an example of the battery cell of the present application shown in Fig. 5A.
In the battery cell 5 of the present application, the outer package may include a case 51 and a cover plate 53. The case 51 may include a bottom plate and a side plate connected to the bottom plate, with the bottom plate and the side plate enclosing to form an accommodating cavity. The case 51 has an opening that communicates with the accommodating cavity, and the cover plate 53 can cover the opening to close the accommodating cavity. The positive electrode sheet, the negative electrode sheet and the separator may form an electrode assembly (i.e., a battery cell sub-unit) 52 by a winding process or a lamination process. The electrode assembly is encapsulated in the accommodating cavity, and the electrolyte solution is infiltrated in the electrode assembly 52. There are three or more electrode assemblies 52 included in the battery cell 5.

[Battery module]

In the present application, a "battery module" is formed by electrically connecting a certain number of battery cells together and putting them into a frame in order to protect the battery cells from external impact, heat, vibration, etc. The shape of the battery cell in the present application may be cylindrical, square, or any other shape.

In the present application, a number of battery cells may be assembled together to form a battery module, and the battery module includes two or more battery cells, the specific number of which depends on the application of the battery module and the parameters of a single battery module.

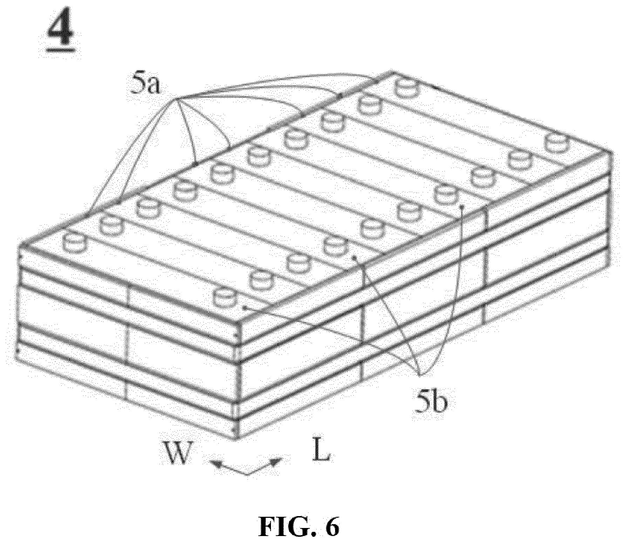

Fig. 6 is a schematic diagram showing an example of a battery module of the present application. Referring to Fig. 6, in the battery module 4, a plurality of battery cells 5a, 5b may be sequentially arranged in the length direction of the battery module 4. Of course, any other arrangement is also possible. The plurality of battery cells 5a, 5b may be further fixed by means of fasteners. Optionally, the battery module 4 may further include a shell having an accommodating space, in which the plurality of battery cells 5a, 5b are accommodated.

[Battery pack]

Another aspect of the present application provides a battery pack, including the battery module of any one or more types of the present application. The number of battery modules contained in the battery pack can be adjusted according to the application and capacity of the battery pack. Optionally, the battery pack may further include auxiliary members such as a battery management system module and cooling/heating components.

In some embodiments, the battery pack includes two or more battery modules, each battery module being a battery module as described in the present application. The battery pack has high safety, and at the same time, the capacity decay trends of the different chemical system battery cells are basically the same, so that the cycle life of the battery pack can be significantly prolonged.

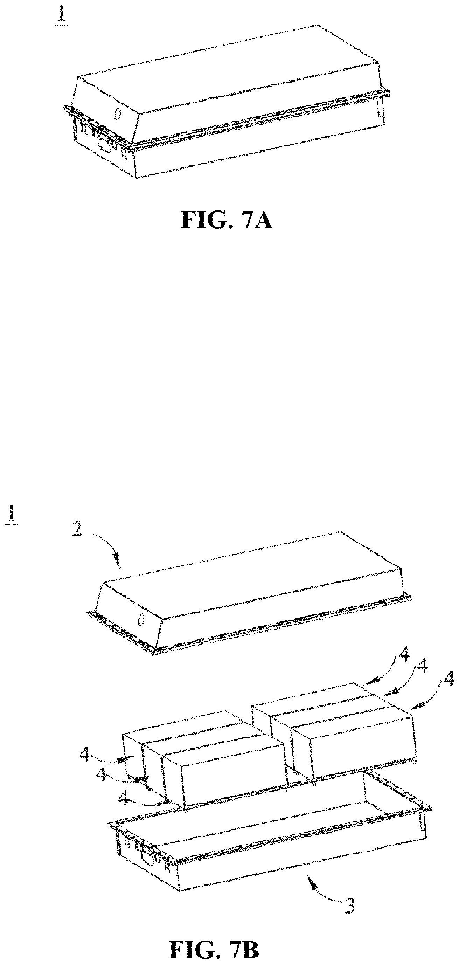

Fig. 7A is a schematic diagram showing an example of a battery pack of the present application. Fig. 7B is an exploded view showing an example of the battery pack of the present application shown in Fig. 7A.

Referring to Figs. 7A and 7B, the battery pack 1 may include a battery box and a plurality of battery modules 4 arranged in the battery box. The battery box includes an upper box 2 and a lower box 3. The upper box 2 can cover the lower box 3 and forms an enclosed space for accommodating the battery modules 4. The plurality of battery modules 4 may be arranged in the battery box in any manner.

[Electrical apparatus]

Another aspect of the present application further provides an electrical apparatus, including the battery module or the battery pack described in the present application. The battery module or the battery pack may be used as a power source for the electrical apparatus to provide power to the electrical apparatus, or may be used as an energy storage unit for the electrical apparatus. The electrical apparatus may be, but is not limited to, a mobile device (such as a mobile phone, a laptop), an electric vehicle (such as an all-electric vehicle, a hybrid electric vehicle, a plug-in hybrid electric vehicle, an electric bicycle, an electric scooter, an electric golf cart, an electric truck), an electric train, a ship, a satellite, an energy storage system, etc. For the electrical apparatus, an electrochemical apparatus such as a battery module or a battery pack may be selected according to its use requirements.

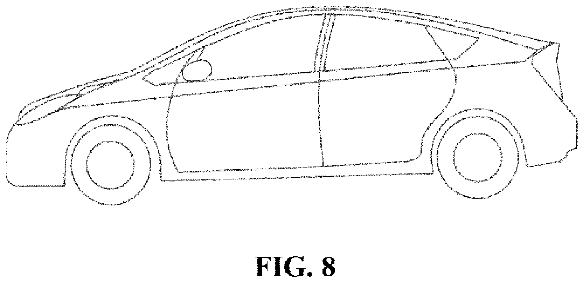

Fig. 8 is an example of an electrical apparatus. The electrical apparatus is an all-electric vehicle, a hybrid electric vehicle, a plug-in hybrid electric vehicle, or the like. The electrical apparatus may use a battery pack or a battery module.

**Examples**

Technical solutions of the present application and advantages thereof are described in detail below with specific examples.

[Preparation of battery cell]

Referring to GB/T 31484-2015 "Cycle Life Requirements and Test Methods of Power Batteries for Electric Vehicles", the preparation methods of battery cells in examples and comparative examples are as follows.

1. Preparation of positive electrode slurry

A positive electrode active material $LiNi_{0.8}Co_{0.1}Mn_{0.1}O_2$, a conductive carbon Super P, and a binder polyvinylidene fluoride (PVDF) are fully stirred and mixed at a weight ratio of 97.5:1.5:1 in an appropriate amount of a solvent of N-methyl pyrrolidone (abbreviated as NMP) to form a uniform and stable slurry with a viscosity of 10,000 mPa•s. The slurry generates no gelling, stratification or sedimentation and other phenomena within 24 hours of standing.

At the same time, three kinds of slurries are prepared from the positive electrode active material $LiNi_{0.8}Co_{0.1}Mn_{0.1}O_2$, the conductive carbon Super P, and the binder polyvinylidene fluoride (PVDF) at the ratios of 96.5:1.5:2, 95.5:1.5:3, 94.5:1.5:4 respectively.

2. Preparation of positive electrode sheet

The above-mentioned various positive electrode active material slurries are respectively uniformly coated on a positive electrode current collector Al foil, the electrode sheet is cold-pressed to a design pressing pressure after drying, and multiple kinds of positive electrode sheets are obtained by slitting the electrode sheet for later use after transfer welding and laser die-cutting.

3. Preparation of electrolyte solution

An equal volume of ethylene carbonate is dissolved in propylene carbonate, and then lithium hexafluorophosphate is uniformly dissolved in the mixed solvent (the concentration of lithium hexafluorophosphate is 1.0 M/L) for later use to obtain the electrolyte solution.

4. Preparation of negative electrode sheet

A negative electrode active material graphite, conductive carbon, a binder polystyrene-butadiene copolymer (SBR), a thickener sodium carboxymethylcellulose (CMC) are fully stirred and mixed at a weight ratio of 96.2:0.8: 1.8: 1.2 in an appropriate amount of water solvent to form a uniform and stable negative electrode slurry; and the slurry is evenly coated on a negative electrode current collector Cu foil, the electrode sheet is cold pressed to a design pressing pressure after drying, and is slit for later use after laser die-cutting.

5. Separator

PE is used as the separator, with one side coated with a 3 $\mu$m thick CCS layer is coated on one side, and two sides each coated with a PCS layer with a weight of 1.5 mg/1540.25 $mm^2$.

6. Preparation of bare battery cell

The positive electrode sheet, the separator and the negative electrode sheet are wound together by using a conventional battery cell manufacturing process to form a bare battery cell. First, a test winding is carried out, and then hot pressing is performed. A micrometer is used to measure the thickness of the bare battery cell that has been subjected to the test winding after hot pressing, and the size is adjusted according to the measurement result, and re-winding is carried out until the bare battery cell with a design thickness is obtained. According to the above method, multiple kinds of electrode sheets are respectively used to produce bare battery cells with multiple thicknesses.

7. Preparation of battery cell

For the bare battery cells that have been wound and hot-pressed, according to the design thickness, tabs of a plurality of bare battery cells are welded to a top cover, the bare battery cells are then placed in a battery cell case, the electrolyte solution is injected, then the procedures such as chemical formation and sealing are carried out, and a rechargeable power battery cell is obtained at last.

[Design of the internal structure of a battery cell]

<Design of dry battery cell nail penetration short-circuit resistance of a battery cell sub-unit in a battery cell>

Through the above method of [Preparation of battery cell], and by adjusting the thickness of the support layer of the positive electrode current collector, the resistivity of the metal layer of the positive electrode current collector, the thickness of the metal layer of the positive electrode current collector, the coating weight of the electrode sheet, the content of the binder in the electrode sheet, the compaction density of the electrode sheet, and the thickness of the separator for the battery cell sub-unit of the intermediate portion and the battery cell sub-units of the side portions, the dry battery cell nail penetration short-circuit resistance of the battery cell sub-unit of the intermediate portion and the dry battery cell nail penetration short-circuit resistance of the battery cell sub-units of the side portions are changed, so that battery cells of Examples 1 and 2 below and battery cells of Comparative Examples 1-1, 1-2, 2-1 and 2-2 can be obtained. In Example 1, the battery cell includes three battery cell sub-units, and in Example 2, the battery cell includes five battery cell sub-units. A structure in which the battery cell sub-unit of the intermediate portion has a dry battery cell nail penetration short-circuit resistance greater than that of the battery cell sub-unit of the side portion is adopted in each of Examples 1 and 2.

In Comparative Examples 1-1 and 1-2, the battery cell includes three battery cell sub-units, and in Comparative Examples 2-1 and 2-2, the battery cell includes five battery cell sub-units. In Comparative Examples 1-1 and 2-1, the battery cell sub-unit of the intermediate portion has a dry battery cell nail penetration short-circuit resistance equal to that of the battery cell sub-unit of the side portion, and in Comparative Examples 1-2 and 2-2, the battery cell sub-unit of the intermediate portion has a dry battery cell nail penetration short-circuit resistance smaller than that of the battery cell sub-unit of the side portion.

By testing Examples 1,2 and Comparative Examples 1-1, 1-2, 2-1 and 2-2, Table 1 below can be obtained, which shows the results of comparison between Examples 1 and 2 and Comparative Examples 1-1, 1-2, 2-1 and 2-2.

Table 1

| Table 1 | Number of battery cell sub-units | Thickness of a support layer of a positive electrode current collector ($\mu$m) | Resistivity of a metal layer of the positive electrode current collector ($*10^{-8}$ $\Omega$m) | Thickness of the metal layer of the positive electrode current collector ($\mu$m) | Coating weight of an electrode sheet (g/1540 mm$^2$) | Content of a binder in the electrode sheet (% by weight) | Compaction density of the electrode sheet (g/cm$^3$) | Thickness of a separator ($\mu$m) | DCR (m$\Omega$) | 2C rate capacity retention rate | Capacity (Ah) | Whether it passed a low-speed nail penetration test | Whether it passed a high-speed nail penetration test | Nail penetration short-circuit resistance (m$\Omega$) |
|---|---|---|---|---|---|---|---|---|---|---|---|---|---|---|
| Comparative Example 1-1 | 3 | 8/8/8 | 4.1/4.1/4.1 | 0.9/0.9/0.9 | 0.297/0.297/0.297 | 1.7%/1.7%/1.7% | 3.35/3.35/3.35 | 9/9/9 | 1.53 | 93.0% | 62.3 | No | No | 16.2/16.2/16.2 |
| Comparative Example 1-2 | 3 | 12/6/12 | 4.5/3.9/4.5 | 0.7/1.0/0.7 | 0.251/0.32/0.251 | 3.1%/1%/3.1% | 3.05/3.5/3.05 | 13/7/13 | 1.59 | 92.0% | 61.1 | No | No | 20.4/14.7/20.4 |
| Example 1 | 3 | 6/12/6 | 3.9/4.5/3.9 | 1.0/0.7/1.0 | 0.32/0.251/0.32 | 1%/3.1%/1% | 3.5/3.05/3.5 | 7/13/7 | 1.53 | 93.1% | 62.3 | Yes | Yes | 14.7/20.4/14.7 |
| Comparative Example 2-1 | 5 | 8/8/8/8/8 | 4.0/4.0/4.0/4.0/4.0 | 0.94/0.94/0.94/0.94 | 0.29/0.29/0.29/0.29/0.29 | 2%/2%/2%/2%/2% | 3.36/3.36/3.36/3.36/3.36 | 9/9/9/9/9 | 1.48 | 93.5% | 62.6 | No | No | 26.9/26.9/26.9/26.9/26.9 |
| Comparative Example 2-2 | 5 | 12/8/6/8/12 | 4.4/4.1/3.7/4.1/4.4 | 0.7/0.9/1.1/0.9/0.7 | 0.25/0.28/0.32/0.28/0.25 | 4%/2%/1%/2%/4% | 3.0/3.4/3.5/3.4/3.0 | 13/9/7/9/13 | 1.55 | 92.2% | 61.4 | No | No | 29.7/27.4/25.5/27.4/29.7 |
| Example 2 | 5 | 6/8/12/8/6 | 3.7/4.1/4.4/4.1/3.7 | 1.1/0.9/0.7/0.9/1.1 | 0.32/0.28/0.25/0.28/0.32 | 1%/2%/4%/2%/1% | 3.5/3.4/3.0/3.4/3.5 | 7/9/13/9/7 | 1.47 | 93.5% | 62.6 | Yes | Yes | 23.1/28.2/35.7/28.2/23.1 |

According to Table 1 above, it can be seen that compared with Comparative Example 1-1 which adopts the structure in which the battery cell sub-unit of the intermediate portion has a dry battery cell nail penetration short-circuit resistance equal to that of the battery cell sub-unit of the side portion, Example 1 which adopts the structure in which the battery cell sub-unit of the intermediate portion has a dry battery cell nail penetration short-circuit resistance greater than that of the battery cell sub-unit of the side portion can pass the low-speed and high-speed nail penetration tests while maintaining basically the same DCR, 2C rate-capacity retention rate and capacity of the battery cell, whereas Comparative Example 1-1 can neither pass the low-speed nail penetration test nor the high-speed nail penetration test. That is to say, in Example 1, the nail penetration weak point of the intermediate portion is improved by increasing the dry battery cell nail penetration short-circuit resistance of the battery cell sub-unit of the intermediate portion, and the loss of DCR and rate performance of the battery cell sub-unit of the intermediate portion be compensated for by properly improving the conductivity/rate performance of the battery cell sub-units of the side portions, so that the safety of the battery cell can be improved without reducing the performance of the battery cell such as the energy density and the rate performance.

In addition, compared with Comparative Example 1-2 which adopts the structure in which the battery cell sub-unit of the intermediate portion has a dry battery cell nail penetration short-circuit resistance smaller than that of the battery cell sub-unit of the side portion, Example 1 which adopts the structure in which the battery cell sub-unit of the intermediate portion has a dry battery cell nail penetration short-circuit resistance greater than that of the battery cell sub-unit of the side portion can obtain a smaller DCR, a higher 2C rate-capacity retention rate and a greater capacity of the battery cell, and Example 1 can pass the low-speed and high-speed nail penetration tests, whereas Comparative Example 1-2 can neither pass the low-speed nail penetration test nor the high-speed nail penetration test. That is, Comparative Example 1-2 clearly shows that arranging the battery cell sub-units with a larger dry battery cell nail penetration short-circuit resistance on two sides is not beneficial for the nail penetration tests.

In addition, compared with Comparative Example 2-1 which adopts the structure in which the battery cell sub-unit of the intermediate portion has a dry battery cell nail penetration short-circuit resistance equal to that of the battery cell sub-unit of the side portion, Example 2 which adopts the structure in which the battery cell sub-unit of the intermediate portion has a dry battery cell nail penetration short-circuit resistance greater than that of the battery cell sub-unit of the side portion can pass the low-speed and high-speed nail penetration tests while maintaining basically the same DCR, 2C rate-capacity retention rate and capacity of the battery cell, whereas Comparative Example 2-1 can neither pass the low-speed nail penetration test nor the high-speed nail penetration test. That is to say, in Example 2, the nail penetration weak point of the intermediate portion is improved by increasing the dry battery cell nail penetration short-circuit resistance of the battery cell sub-unit of the intermediate portion, and the loss of DCR and rate performance of the battery cell sub-unit of the intermediate portion be compensated for by properly improving the conductivity/rate performance of the battery cell sub-units of the side portions, so that the safety of the battery cell can be improved without reducing the performance of the battery cell such as the energy density and the rate performance.

In addition, compared with Comparative Example 2-2 which adopts the structure in which the battery cell sub-unit of the intermediate portion has a dry battery cell nail penetration short-circuit resistance smaller than that of the battery cell sub-unit of the side portion, Example 2 which adopts the structure in which the battery cell sub-unit of the intermediate portion has a dry battery cell nail penetration short-circuit resistance greater than that of the battery cell sub-unit of the side portion can obtain a smaller DCR, a higher 2C rate-capacity retention rate and a greater capacity of the battery cell, and Example 2 can pass the low-speed and high-speed nail penetration tests, whereas Comparative Example 2-2 can neither pass the low-speed nail penetration test nor the high-speed nail penetration test. That is, Comparative Example 2-2 clearly shows that arranging the battery cell sub-units with a larger dry battery cell nail penetration short-circuit resistance on two sides is not beneficial for the nail penetration tests.

It needs to be explained here that the total thickness of the battery cell of all the cases in Table 1 is the same. Example 2 and Comparative Examples 2-1 and 2-2 are divided into five battery cell sub-units, so the thickness of a single battery cell sub-unit thereof is smaller than those of Example 1 and Comparative Examples 1-1 and 1-2, and the number of layers of positive and negative electrodes is less, so that the dry battery cell nail penetration short-circuit resistance exhibited is greater than those of Example 1 and Comparative Examples 1-1 and 1-2. The following examples and comparative examples also follow such rules.

<Design of the thickness of a support layer of a positive electrode current collector of a positive electrode sheet of a battery cell sub-unit in a battery cell>

Through the above method of [Preparation of battery cell], and by adjusting the thickness of the support layer of the positive electrode current collector, the resistivity of the metal layer of the positive electrode current collector, the thickness of the metal layer of the positive electrode current collector, the coating weight of the electrode sheet, the content of the binder in the electrode sheet, the compaction density of the electrode sheet, and the thickness of the separator for the battery cell sub-unit of the intermediate portion and the battery cell sub-units of the side portions, battery cells of Examples 3 and 4 below and battery cells of Comparative Examples 3-1, 3-2, 4-1 and 4-2 can be obtained. In Example 3, the battery cell includes three battery cell sub-units, and in Example 4, the battery cell includes five battery cell sub-units. In both Examples 3 and 4, the support layer of the positive electrode current collector of the battery cell sub-unit of the intermediate portion has a thickness greater than that of the support layer of the positive electrode current collector of the battery cell sub-unit of the side portion.

In Comparative Examples 3-1 and 3-2, the battery cell includes three battery cell sub-units, and in Comparative Examples 4-1 and 4-2, the battery cell includes five battery cell sub-units. In Comparative Examples 3-1 and 4-1, the support layer of the positive electrode current collector of the battery cell sub-unit of the intermediate portion has a thickness equal to that of the support layer of the positive electrode current collector of the battery cell sub-unit of the side portion, and in Comparative Examples 3-2 and 4-2, the support layer of the positive electrode current collector of the battery cell sub-unit of the intermediate portion has a thickness smaller than that of the support layer of the positive electrode current collector of the battery cell sub-unit of the side portion.

By testing Examples 3 and 4 and Comparative Examples 3-1, 3-2, 4-1 and 4-2, Table 2 below can be obtained, which shows the results of comparison between Examples 3 and 4 and Comparative Examples 3-1, 3-2, 4-1 and 4-2.

Table 2

| Table 2 | Number of battery cell sub-units | Thickness of a support layer of a positive electrode current collector (μm) | Resistivity of a metal layer of the positive electrode current collector (*$10^{-8}$ Ωm) | Thickness of the metal layer of the positive electrode current collector (μm) | Coating weight of an electrode sheet (g/1540 mm²) | Content of a binder in the electrode sheet (% by weight) | Compaction density of the electrode sheet (g/cm³) | Thickness of a separator (μm) | DCR (mΩ) | 2C rate - capacity retention rate | Capacity (Ah) | Whether it passed a low-speed nail penetration test | Whether it passed a high-speed nail penetration test | Nail penetration short-circuit resistance (mΩ) |
|---|---|---|---|---|---|---|---|---|---|---|---|---|---|---|
| Comparative Example 3-1 | 3 | 8/8/8 | 3.9/4.4/3.9 | 1.0/0.8/1.0 | 0.32/0.27/0.32 | 1%/2.5%/1% | 3.5/3.3/3.5 | 7/12/7 | 1.53 | 93.0% | 62.3 | Yes | No | 15.2/17.4/15.2 |
| Comparative Example 3-2 | 3 | 12/6/12 | 3.9/4.4/3.9 | 1.0/0.8/1.0 | 0.32/0.27/0.32 | 1%/2.5%/1% | 3.5/3.3/3.5 | 7/12/7 | 1.53 | 93.0% | 61.5 | Yes | No | 15.8/17.1/15.8 |
| Example 3 | 3 | 6/12/6 | 3.9/4.4/3.9 | 1.0/0.8/1 0 | 0.32/0.27/0.32 | 1%/2.5%/1% | 3.5/3.3/3.5 | 7/12/7 | 1.52 | 93.0% | 62.3 | Yes | Yes | 14.7/18.4/14.7 |
| Comparative Example 4-1 | 5 | 8/8/8/8/8 | 3.7/4.1/4.3/4.1/3.7 | 1.1/0.9/0.8/0.9/1.1 | 0.32/0.28/0.27/0.28/0.32 | 1%/2%/3%/2%/1% | 3.5/3.4/3.3/3.4/3.5 | 7/9/12/9/7 | 1.46 | 93.7% | 62.8 | Yes | No | 23.7/28.2/32.0/28.2/237 |
| Comparative Example 4-2 | 5 | 12/8/6/8/12 | 3.7/4.1/4.3/4.1/3.7 | 1.1/0.9/0.8/0.9/1.1 | 0.32/0.28/0.27/0.28/0.32 | 1%/2%/3%/2%/1% | 3.5/3.4/3.3/3.4/3.5 | 7/9/12/9/7 | 1.46 | 93.7% | 61.9 | Yes | No | 24.2/28.2/31.3/28.2/242 |
| Example 4 | 5 | 6/8/12/8/6 | 3.7/4.1/4.3/4.1/3.7 | 1.1/0.9/0.8/0.9/1.1 | 0.32/0.28/0.27/0.28/0.32 | 1%/2%/3%/2%/1% | 3.5/3.4/3.3/3.4/3.5 | 7/9/12/9/7 | 1.46 | 93.8% | 62.8 | Yes | Yes | 23.1/28.2/33.7/28.2/23.1 |

EP 4 228 048 A1

According to Table 2 above, it can be seen that compared with Comparative Example 3-1 which adopts the structure in which the support layer of the positive electrode current collector of the battery cell sub-unit of the intermediate portion has a thickness equal to that of the support layer of the positive electrode current collector of the battery cell sub-unit of the side portion, Example 3 which adopts the structure in which the support layer of the positive electrode current collector of the battery cell sub-unit of the intermediate portion has a thickness greater than that of the support layer of the positive electrode current collector of the battery cell sub-unit of the side portion can pass the low-speed and high-speed nail penetration tests while maintaining basically the same DCR, 2C rate-capacity retention rate and capacity of the battery cell, whereas Comparative Example 3-1 can only pass the low-speed nail penetration test but cannot pass the high-speed nail penetration test.

In addition, compared with Comparative Example 3-2 which adopts the structure in which the support layer of the positive electrode current collector of the battery cell sub-unit of the intermediate portion has a thickness smaller than that of the support layer of the positive electrode current collector of the battery cell sub-unit of the side portion, Example 3 which adopts the structure in which the support layer of the positive electrode current collector of the battery cell sub-unit of the intermediate portion has a thickness greater than that of the support layer of the positive electrode current collector of the battery cell sub-unit of the side portion can obtain a greater capacity of the battery cell, and Example 3 can pass the low-speed and high-speed nail penetration tests, whereas Comparative Example 3-2 can only pass the low-speed nail penetration test but cannot pass the high-speed nail penetration test. That is to say, Example 3 can improve the safety of the battery cell without reducing the performance of the battery cell such as the energy density.

In addition, compared with Comparative Example 4-1 which adopts the structure in which the support layer of the positive electrode current collector of the battery cell sub-unit of the intermediate portion has a thickness equal to that of the support layer of the positive electrode current collector of the battery cell sub-unit of the side portion, Example 4 which adopts the structure in which the support layer of the positive electrode current collector of the battery cell sub-unit of the intermediate portion has a thickness greater than that of the support layer of the positive electrode current collector of the battery cell sub-unit of the side portion can pass the low-speed and high-speed nail penetration tests while maintaining basically the same DCR, 2C rate-capacity retention rate and capacity of the battery cell, whereas Comparative Example 4-1 can only pass the low-speed nail penetration test but cannot pass the high-speed nail penetration test.

In addition, compared with Comparative Example 4-2 which adopts the structure in which the support layer of the positive electrode current collector of the battery cell sub-unit of the intermediate portion has a thickness smaller than that of the support layer of the positive electrode current collector of the battery cell sub-unit of the side portion, Example 4 which adopts the structure in which the support layer of the positive electrode current collector of the battery cell sub-unit of the intermediate portion has a thickness greater than that of the support layer of the positive electrode current collector of the battery cell sub-unit of the side portion can obtain a greater capacity of the battery cell, and Example 4 can pass the low-speed and high-speed nail penetration tests, whereas Comparative Example 4-2 can only pass the low-speed nail penetration test but cannot pass the high-speed nail penetration test. That is to say, Example 4 can improve the safety of the battery cell without reducing the performance of the battery cell such as the energy density.

<Design of the resistivity of a metal layer of a positive electrode current collector of a positive electrode sheet of a battery cell sub-unit in a battery cell>

Through the above method of [Preparation of battery cell], and by adjusting the thickness of the support layer of the positive electrode current collector, the resistivity of the metal layer of the positive electrode current collector, the thickness of the metal layer of the positive electrode current collector, the coating weight of the electrode sheet, the content of the binder in the electrode sheet, the compaction density of the electrode sheet, and the thickness of the separator for the battery cell sub-unit of the intermediate portion and the battery cell sub-units of the side portions, battery cells of Examples 5 and 6 below and battery cells of Comparative Examples 5-1, 5-2, 6-1 and 6-2 can be obtained. In Example 5, the battery cell includes three battery cell sub-units, and in Example 6, the battery cell includes five battery cell sub-units. A structure in which the metal layer of the positive electrode current collector of the battery cell sub-unit of the intermediate portion has a resistivity greater than that of the metal layer of the positive electrode current collector of the battery cell sub-unit of the side portion is adopted in each of Examples 5 and 6.

In Comparative Examples 5-1 and 5-2, the battery cell includes three battery cell sub-units, and in Comparative Examples 6-1 and 6-2, the battery cell includes five battery cell sub-units. In Comparative Examples 5-1 and 6-1, the metal layer of the positive electrode current collector of the battery cell sub-unit of the intermediate portion has a resistivity equal to that of the metal layer of the positive electrode current collector of the battery cell sub-unit of the side portion, and in Comparative Examples 5-2 and 6-2, the metal layer of the positive electrode current collector of the battery cell sub-unit of the intermediate portion has a resistivity smaller than that of the metal layer of the positive electrode current collector of the battery cell sub-unit of the side portion.

By testing Examples 5 and 6 and Comparative Examples 5-1, 5-2, 6-1 and 6-2, Table 3 below can be obtained, which shows the results of comparison between Examples 5 and 6 and Comparative Examples 5-1, 5-2, 6-1 and 6-2.

Table 3

| Table 3 | Number of battery cell sub-units | Thickness of a support layer of a positive electrode current col-lector ($\mu$m) | Resistivity of a metal layer of the positive electrode current col-lector ($^*10^{-8}$ $\Omega$m) | Thickness of the metal layer of the positive electrode current col-lector ($\mu$m) | Coating weight of an elec-trode sheet (g/1540 mm$^2$) | Content of a binder in the electrode sheet (% by weight) | Compaction density of the elec-trode sheet (g/cm$^3$) | Thickness of a sepa-rator ($\mu$m) | DCR (m$\Omega$) | 2C rate - capacity retention rate | Capacity (Ah) | Whether it passed a low-speed nail penetration test | Whether it passed a high-speed nail pene-tration test | Nail penetra-tion short-cir-cuit resistance (m$\Omega$) |
|---|---|---|---|---|---|---|---|---|---|---|---|---|---|---|
| Comparative Example 5-1 | 3 | 6/10/6 | 4.1/4.1/4.1 | 1.0/0.8/1.0 | 0.32/0.27/0.32 | 1%/2.5%/1% | 3.5/3.3/3.5 | 7/12/7 | 1.53 | 92.8% | 62.2 | Yes | No | 15.3/17.5/15 3 |
| Comparative Example 5-2 | 3 | 6/10/6 | 4.5/3.9/4.5 | 1.0/0.8/1.0 | 0.32/0.27/0.32 | 1%/2.5%/1% | 3.5/3.3/3.5 | 7/12/7 | 1.68 | 91.2% | 61.8 | Yes | No | 16.0/17.3/16 0 |
| Example 5 | 3 | 6/10/6 | 3.9/4.5/3.9 | 1.0/0.8/1.0 | 0.32/0.27/0.32 | 1%/2.5%/1% | 3.5/3.3/3.5 | 7/12/7 | 1.53 | 92.7% | 62.2 | Yes | Yes | 14.7/18.6/14 7 |
| Comparative Example 6-1 | 5 | 6/8/1 0/8/6 | 4.0/4.0/4.0/4.0/4.0 | 1.1/0.9/0.8/0.9/1.1 | 0.32/0.28/0.27/0.28/0.32 | 1%/2%/3%/2%/1% | 3.5/3.4/3.3/3.4/3.5 | 7/9/12/9/7 | 1.45 | 93.7% | 62.6 | Yes | No | 24.0/28.2/31.3/28.2/24.0 |
| Comparative Example 6-2 | 5 | 6/8/10/8/6 | 4.5/4.0/3.7/4.0/4.5 | 1.1/0.9/0.8/0.9/1.1 | 0.32/0.28/0.27/0.28/0.32 | 1%/2%/3%/2%/1% | 3.5/3.4/3.3/3.4/3.5 | 7/9/12/9/7 | 1.51 | 92.4% | 61.9 | Yes | No | 24.7/28.2/30.6/28.2/24.7 |
| Example 6 | 5 | 6/8/1 0/8/6 | 3.7/4.1/4.4/4.1/3.7 | 1.1/0.9/0.8/0.9/1.1 | 0.32/0.28/0.27/0.28/0.32 | 1%/2%/3%/2%/1% | 3.5/3.4/3.3/3.4/3.5 | 7/9/12/9/7 | 1.45 | 93.7% | 62.7 | Yes | Yes | 23.1/28.2/33.9/28.2/23.1 |

According to Table 3 above, it can be seen that compared with Comparative Example 5-1 which adopts the structure in which the metal layer of the positive electrode current collector of the battery cell sub-unit of the intermediate portion has a resistivity equal to that of the metal layer of the positive electrode current collector of the battery cell sub-unit of the side portion, Example 5 which adopts the structure in which the metal layer of the positive electrode current collector of the battery cell sub-unit of the intermediate portion has a resistivity greater than that of the metal layer of the positive electrode current collector of the battery cell sub-unit of the side portion can pass the low-speed and high-speed nail penetration tests while maintaining basically the same DCR, 2C rate-capacity retention rate and capacity of the battery cell, whereas Comparative Example 5-1 can only pass the low-speed nail penetration test but cannot pass the high-speed nail penetration test.

In addition, compared with Comparative Example 5-2 which adopts the structure in which the metal layer of the positive electrode current collector of the battery cell sub-unit of the intermediate portion has a resistivity smaller than that of the metal layer of the positive electrode current collector of the battery cell sub-unit of the side portion, Example 5 which adopts the structure in which the metal layer of the positive electrode current collector of the battery cell sub-unit of the intermediate portion has a resistivity greater than that of the metal layer of the positive electrode current collector of the battery cell sub-unit of the side portion can obtain a smaller DCR, a higher 2C rate-capacity retention rate and a similar capacity of the battery cell, and Example 5 can pass the low-speed and high-speed nail penetration tests, whereas Comparative Example 5-2 can only pass the low-speed nail penetration test but cannot pass the high-speed nail penetration test. That is to say, Example 5 can improve the safety of the battery cell without reducing the performance of the battery cell such as the energy density and the rate performance.

In addition, compared with Comparative Example 6-1 which adopts the structure in which the metal layer of the positive electrode current collector of the battery cell sub-unit of the intermediate portion has a resistivity equal to that of the metal layer of the positive electrode current collector of the battery cell sub-unit of the side portion, Example 6 which adopts the structure in which the metal layer of the positive electrode current collector of the battery cell sub-unit of the intermediate portion has a resistivity greater than that of the metal layer of the positive electrode current collector of the battery cell sub-unit of the side portion can pass the low-speed and high-speed nail penetration tests while maintaining basically the same DCR, 2C rate-capacity retention rate and capacity of the battery cell, whereas Example 6-1 can only pass the low-speed nail penetration test but cannot pass the high-speed nail penetration test.

In addition, compared with Comparative Example 6-2 which adopts the structure in which the metal layer of the positive electrode current collector of the battery cell sub-unit of the intermediate portion has a resistivity smaller than that of the metal layer of the positive electrode current collector of the battery cell sub-unit of the side portion, Example 6 which adopts the structure in which the metal layer of the positive electrode current collector of the battery cell sub-unit of the intermediate portion has a resistivity greater than that of the metal layer of the positive electrode current collector of the battery cell sub-unit of the side portion can obtain a smaller DCR, a higher 2C rate-capacity retention rate and a greater capacity of the battery cell, and Example 6 can pass the low-speed and high-speed nail penetration tests, whereas Comparative Example 6-2 can only pass the low-speed nail penetration test but cannot pass the high-speed nail penetration test. That is to say, Example 6 can improve the safety of the battery cell without reducing the performance of the battery cell such as the energy density and the rate performance.

<Design of the thickness of a metal layer of a positive electrode current collector of a positive electrode sheet of a battery cell sub-unit in a battery cell>

Through the above method of [Preparation of battery cell], and by adjusting the thickness of the support layer of the positive electrode current collector, the resistivity of the metal layer of the positive electrode current collector, the thickness of the metal layer of the positive electrode current collector, the coating weight of the electrode sheet, the content of the binder in the electrode sheet, the compaction density of the electrode sheet, and the thickness of the separator for the battery cell sub-unit of the intermediate portion and the battery cell sub-units of the side portions, battery cells of Examples 7 and 8 below and battery cells of Comparative Examples 7-1, 7-2, 8-1 and 8-2 can be obtained. In Example 7, the battery cell includes three battery cell sub-units, and in Example 8, the battery cell includes five battery cell sub-units. A structure in which the metal layer of the positive electrode current collector of the battery cell sub-unit of the intermediate portion has a thickness smaller than that of the metal layer of the positive electrode current collector of the battery cell sub-unit of the side portion is adopted in each of Examples 7 and 8.

In Comparative Examples 7-1 and 7-2, the battery cell includes three battery cell sub-units, and in Comparative Examples 8-1 and 8-2, the battery cell includes five battery cell sub-units. In Comparative Examples 7-1 and 8-1, the metal layer of the positive electrode current collector of the battery cell sub-unit of the intermediate portion has a thickness equal to that of the metal layer of the positive electrode current collector of the battery cell sub-unit of the side portion, and in Comparative Examples 7-2 and 8-2, the metal layer of the positive electrode current collector of the battery cell sub-unit of the intermediate portion has a thickness greater than that of the metal layer of the positive electrode current collector of the battery cell sub-unit of the side portion.

By testing Examples 7 and 8 and Comparative Examples 7-1, 7-2, 8-1 and 8-2, Table 4 below can be obtained, which shows the results of comparison between Examples 7 and 8 and Comparative Examples 7-1, 7-2, 8-1 and 8-2.

Table 4

| Table 4 | Number of battery cell sub-units | Thickness of a support layer of a positive electrode current collector ($\mu$m) | Resistivity of a metal layer of the positive electrode current collector ($*10^{-8}$ $\Omega$m) | Thickness of the metal layer of the positive electrode current collector ($\mu$m) | Coating weight of an electrode sheet (g/1540 mm$^2$) | Content of a binder in the electrode sheet (% by weight) | Compaction density of the electrode sheet (g/cm$^3$) | Thickness of a separator ($\mu$m) | DCR (m$\Omega$) | 2C rate - capacity retention rate | Capacity (Ah) | Whether it passed a low-speed nail penetration test | Whether it passed a high-speed nail penetration test | Nail penetration short-circuit resistance (m$\Omega$) |
|---|---|---|---|---|---|---|---|---|---|---|---|---|---|---|
| Comparative Example 7-1 | 3 | 6/10/6 | 3.9/4.4/3.9 | 0.9/0.9/0.9 | 0.32/0.27/0.32 | 1%/2.5%/1% | 3.5/3.3/3.5 | 7/12/7 | 1.53 | 93.0% | 62.1 | Yes | No | 15.2/17.4/15.2 |
| Comparative Example 7-2 | 3 | 6/10/6 | 3.9/4.4/3.9 | 0.7/1.0/0.7 | 0.32/0.27/0.32 | 1%/2.5%/1% | 3.5/3.3/3.5 | 7/12/7 | 1.71 | 91.2% | 61.5 | Yes | No | 16.1/17.0/16.1 |
| Example 7 | 3 | 6/10/6 | 3.9/4.4/3.9 | 1.0/0.7/1.0 | 0.32/0.27/0.32 | 1%/2.5%/1% | 3.5/3.3/3.5 | 7/12/7 | 1.53 | 92.9% | 62.1 | Yes | Yes | 14.7/18.8/14.7 |
| Comparative Example 8-1 | 5 | 6/8/10/8/6 | 3.7/4.1/4.3/4.1/3.7 | 0.94/0.94/0.94 | 0.32/0.28/0.27/0.28/0.32 | 1%/2%/3%/2%/1% | 3.5/3.4/3.3/3.4/3.5 | 7/9/12/9/7 | 1.50 | 93.4% | 62.3 | Yes | No | 23.9/28.4/31.4/28.4/23.9 |
| Comparative Example 8-2 | 5 | 6/8/10/8/6 | 3.7/4.1/4.3/4.1/3.7 | 0.7/0.9/1.1/0.9/0.7 | 0.32/0.28/0.27/0.28/0.32 | 1%/2%/3%/2%/1% | 3.5/3.4/3.3/3.4/3.5 | 7/9/12/9/7 | 1.69 | 91.5% | 61.7 | Yes | No | 24.5/28.2/30.5/28.2/24.5 |
| Example 8 | 5 | 6/8/10/8/6 | 3.7/4.1/4.3/4.1/3.7 | 1.1/0.9/0.7/0.9/1.1 | 0.32/0.28/0.27/0.28/0.32 | 1%/2%/3%/2%/1% | 3.5/3.4/3.3/3.4/3.5 | 7/9/12/9/7 | 1.50 | 93.5% | 62.3 | Yes | Yes | 23.1/28.2/33.8/28.2/23.1 |

According to Table 4 above, it can be seen that compared with Comparative Example 7-1 which adopts the structure in which the metal layer of the positive electrode current collector of the battery cell sub-unit of the intermediate portion has a thickness equal to that of the metal layer of the positive electrode current collector of the battery cell sub-unit of the side portion, Example 7 which adopts the structure in which the metal layer of the positive electrode current collector of the battery cell sub-unit of the intermediate portion has a thickness smaller than that of the metal layer of the positive electrode current collector of the battery cell sub-unit of the side portion can pass the low-speed and high-speed nail penetration tests while maintaining basically the same DCR, 2C rate-capacity retention rate and capacity of the battery cell, whereas Comparative Example 7-1 can only pass the low-speed nail penetration test but cannot pass the high-speed nail penetration test.

In addition, compared with Comparative Example 7-2 which adopts the structure in which the metal layer of the positive electrode current collector of the battery cell sub-unit of the intermediate portion has a thickness greater than that of the metal layer of the positive electrode current collector of the battery cell sub-unit of the side portion, Example 7 which adopts the structure in which the metal layer of the positive electrode current collector of the battery cell sub-unit of the intermediate portion has a thickness smaller than that of the metal layer of the positive electrode current collector of the battery cell sub-unit of the side portion can obtain a smaller DCR, a higher 2C rate-capacity retention rate and a greater capacity of the battery cell, and Example 7 can pass the low-speed and high-speed nail penetration tests, whereas Comparative Example 7-2 can only pass the low-speed nail penetration test but cannot pass the high-speed nail penetration test. That is to say, Example 7 can improve the safety of the battery cell without reducing the performance of the battery cell such as the energy density and the rate performance.

In addition, compared with Comparative Example 8-1 which adopts the structure in which the metal layer of the positive electrode current collector of the battery cell sub-unit of the intermediate portion has a thickness equal to that of the metal layer of the positive electrode current collector of the battery cell sub-unit of the side portion, Example 8 which adopts the structure in which the metal layer of the positive electrode current collector of the battery cell sub-unit of the intermediate portion has a thickness smaller than that of the metal layer of the positive electrode current collector of the battery cell sub-unit of the side portion can pass the low-speed and high-speed nail penetration tests while maintaining basically the same DCR, 2C rate-capacity retention rate and capacity of the battery cell, whereas Comparative Example 8-1 can only pass the low-speed nail penetration test but cannot pass the high-speed nail penetration test.

In addition, compared with Comparative Example 8-2 which adopts the structure in which the metal layer of the positive electrode current collector of the battery cell sub-unit of the intermediate portion has a thickness greater than that of the metal layer of the positive electrode current collector of the battery cell sub-unit of the side portion, Example 8 which adopts the structure in which the metal layer of the positive electrode current collector of the battery cell sub-unit of the intermediate portion has a thickness smaller than that of the metal layer of the positive electrode current collector of the battery cell sub-unit of the side portion can obtain a smaller DCR, a higher 2C rate-capacity retention rate and a greater capacity of the battery cell, and Example 8 can pass the low-speed and high-speed nail penetration tests, whereas Comparative Example 8-2 can only pass the low-speed nail penetration test but cannot pass the high-speed nail penetration test. That is to say, Example 8 can improve the safety of the battery cell without reducing the performance of the battery cell such as the energy density and the rate performance.

<Design of the coating weight of an electrode sheet of a battery cell sub-unit in a battery cell>

Through the above method of [Preparation of battery cell], and by adjusting the thickness of the support layer of the positive electrode current collector, the resistivity of the metal layer of the positive electrode current collector, the thickness of the metal layer of the positive electrode current collector, the coating weight of the electrode sheet, the content of the binder in the electrode sheet, the compaction density of the electrode sheet, and the thickness of the separator for the battery cell sub-unit of the intermediate portion and the battery cell sub-units of the side portions, battery cells of Examples 9 and 10 below and battery cells of Comparative Examples 9-1, 9-2, 10-1 and 10-2 can be obtained. In Example 9, the battery cell includes three battery cell sub-units, and in Example 10, the battery cell includes five battery cell sub-units. A structure in which the electrode sheet of the battery cell sub-unit of the intermediate portion has a coating weight smaller than that of the electrode sheet of the battery cell sub-unit of the side portion is adopted in each of Examples 9 and 10.

In Comparative Examples 9-1 and 9-2, the battery cell includes three battery cell sub-units, and in Comparative Examples 10-1 and 10-2, the battery cell includes five battery cell sub-units. In Comparative Examples 9-1 and 10-1, the electrode sheet of the battery cell sub-unit of the intermediate portion has a coating weight equal to that of the electrode sheet of the battery cell sub-unit of the side portion, and in Comparative Examples 9-2 and 10-2, the electrode sheet of the battery cell sub-unit of the intermediate portion has a coating weight greater than that of the electrode sheet of the battery cell sub-unit of the side portion.

By testing Examples 9 and 10 and Comparative Examples 9-1, 9-2, 10-1 and 10-2, Table 5 below can be obtained, which shows the results of comparison between Examples 9 and 10 and Comparative Examples 9-1, 9-2, 10-1 and 10-2.

Table 5

| Table 5 | Number of battery cell sub-units | Thickness of a support layer of a positive electrode current collector (μm) | Resistivity of a metal layer of the positive electrode current collector ($*10^{-8}$ Ωm) | Thickness of the metal layer of the positive electrode current collector (μm) | Coating weight of an electrode sheet (g/1540 mm²) | Content of a binder in the electrode sheet (% by weight) | Compaction density of the electrode sheet (g/cm³) | Thickness of a separator (μm) | DCR (mΩ) | 2C rate - capacity retention rate | Capacity (Ah) | Whether it passed a low-speed nail penetration test | Whether it passed a high-speed nail penetration test | Nail penetration short-circuit resistance (mΩ) |
|---|---|---|---|---|---|---|---|---|---|---|---|---|---|---|
| Comparative Example 9-1 | 3 | 6/10/6 | 3.9/4.4/3.9 | 1.0/0.8/1.0 | 0.297/0.297/0.297 | 1%/2.5%/1% | 3.5/3.3/3.5 | 7/12/7 | 1.53 | 93.5% | 62.3 | Yes | No | 15.1/17.3/15.1 |
| Comparative Example 9-2 | 3 | 6/10/6 | 3.9/4.4/3.9 | 1.0/0.8/1.0 | 0.251/0.32/0.251 | 1%/2.5%/1% | 3.5/3.3/3.5 | 7/12/7 | 1.53 | 93.4% | 61.9 | Yes | No | 16.0/16.9/16.0 |
| Example 9 | 3 | 6/10/6 | 3.9/4.4/3.9 | 1.0/0.8/1.0 | 0.32/0.251/0.32 | 1%/2.5%/1% | 3.5/3.3/3.5 | 7/12/7 | 1.52 | 93.5% | 62.3 | Yes | Yes | 14.6/18.7/14.6 |
| Comparative Example 10-1 | 5 | 6/8/10/8/6 | 3.7/4.1/4.3/4.1/3.7 | 1.1/0.9/0.8/0.9/1.1 | 0.29/0.29/0.29/0.29/0.29 | 1%/2%/3%/2%/1% | 3.5/3.4/3.3/3.4/3.5 | 7/9/12/9/7 | 1.53 | 93.5% | 62.4 | Yes | No | 23.8/28.1/31.5/28.1/23.8 |
| Comparative Example 10-2 | 5 | 6/8/10/8/6 | 3.7/4.1/4.3/4.1/3.7 | 1.1/0.9/0.8/0.9/1.1 | 0.25/0.28/0.32/0.28/0.25 | 1%/2%/3%/2%/1% | 3.5/3.4/3.3/3.4/3.5 | 7/9/12/9/7 | 1.53 | 93.5% | 62.0 | Yes | No | 24.1/28.2/30.2/28.2/24.1 |
| Example 10 | 5 | 6/8/10/8/6 | 3.7/4.1/4.3/4.1/3.7 | 1.1/0.9/0.8/0.9/1.1 | 0.32/0.28/0.25/0.28/0.32 | 1%/2%/3%/2%/1% | 3.5/3.4/3.3/3.4/3.5 | 7/9/12/9/7 | 1.52 | 93.5% | 62.4 | Yes | Yes | 23.1/28.2/33.4/28.2/23.1 |

According to Table 5 above, it can be seen that compared with Comparative Example 9-1 which adopts the structure in which the electrode sheet of the battery cell sub-unit of the intermediate portion has a coating weight equal to that of the electrode sheet of the battery cell sub-unit of the side portion, Example 9 which adopts the structure in which the electrode sheet of the battery cell sub-unit of the intermediate portion has a coating weight smaller than that of the electrode sheet of the battery cell sub-unit of the side portion can pass the low-speed and high-speed nail penetration tests while maintaining basically the same DCR, 2C rate-capacity retention rate and capacity of the battery cell, whereas Comparative Example 9-1 can only pass the low-speed nail penetration test but cannot pass the high-speed nail penetration test.

In addition, compared with Comparative Example 9-2 which adopts the structure in which the electrode sheet of the battery cell sub-unit of the intermediate portion has a coating weight greater than that of the electrode sheet of the battery cell sub-unit of the side portion, Example 9 which adopts the structure in which the electrode sheet of the battery cell sub-unit of the intermediate portion has a coating weight smaller than that of the electrode sheet of the battery cell sub-unit of the side portion can obtain a greater capacity of the battery cell, and Example 9 can pass the low-speed and high-speed nail penetration tests, whereas Comparative Example 9-2 can only pass the low-speed nail penetration test but cannot pass the high-speed nail penetration test. That is to say, Example 9 can improve the safety of the battery cell without reducing the performance such as the energy density.

In addition, compared with Comparative Example 10-1 which adopts the structure in which the electrode sheet of the battery cell sub-unit of the intermediate portion has a coating weight equal to that of the electrode sheet of the battery cell sub-unit of the side portion, Example 10 which adopts the structure in which the electrode sheet of the battery cell sub-unit of the intermediate portion has a coating weight smaller than that of the electrode sheet of the battery cell sub-unit of the side portion can pass the low-speed and high-speed nail penetration tests while maintaining basically the same DCR, 2C rate-capacity retention rate and capacity of the battery cell, whereas Comparative Example 10-1 can only pass the low-speed nail penetration test but cannot pass the high-speed nail penetration test.

In addition, compared with Comparative Example 10-2 which adopts the structure in which the electrode sheet of the battery cell sub-unit of the intermediate portion has a coating weight greater than that of the electrode sheet of the battery cell sub-unit of the side portion, Example 10 which adopts the structure in which the electrode sheet of the battery cell sub-unit of the intermediate portion has a coating weight smaller than that of the electrode sheet of the battery cell sub-unit of the side portion can obtain a greater capacity of the battery cell, and Example 10 can pass the low-speed and high-speed nail penetration tests, whereas Comparative Example 10-2 can only pass the low-speed nail penetration test but cannot pass the high-speed nail penetration test. That is to say, Example 10 can improve the safety of the battery cell without reducing the performance of the battery cell such as the energy density.

<Design of the content of a binder in an electrode sheet of a battery cell sub-unit in a battery cell>

Through the above method of [Preparation of battery cell], and by adjusting the thickness of the support layer of the positive electrode current collector, the resistivity of the metal layer of the positive electrode current collector, the thickness of the metal layer of the positive electrode current collector, the coating weight of the electrode sheet, the content of the binder in the electrode sheet, the compaction density of the electrode sheet, and the thickness of the separator for the battery cell sub-unit of the intermediate portion and the battery cell sub-units of the side portions, battery cells of Examples 11 and 12 below and battery cells of Comparative Examples 11-1, 11-2, 12-1 and 12-2 can be obtained. In Example 11, the battery cell includes three battery cell sub-units, and in Example 12, the battery cell includes five battery cell sub-units. A structure in which the binder in the electrode sheet of the battery cell sub-unit of the intermediate portion has a content greater than that of the binder in the electrode sheet of the battery cell sub-unit of the side portion is adopted in each of Examples 11 and 12.

In Comparative Examples 11-1 and 11-2, the battery cell includes three battery cell sub-units, and in Comparative Examples 12-1 and 12-2, the battery cell includes five battery cell sub-units. In Comparative Examples 11-1 and 12-1, the binder in the electrode sheet of the battery cell sub-unit of the intermediate portion has a content equal to that of the binder in the electrode sheet of the battery cell sub-unit of the side portion, and in Comparative Examples 11-2 and 12-2, the binder in the electrode sheet of the battery cell sub-unit of the intermediate portion has a content smaller than that of the binder in the electrode sheet of the battery cell sub-unit of the side portion.

By testing Examples 11 and 12 and Comparative Examples 11-1, 11-2, 12-1 and 12-2, Table 6 below can be obtained, which shows the results of comparison between Examples 11 and 12 and Comparative Examples 11-1, 11-2, 12-1 and 12-2.

Table 6

| Table 6 | Number of battery cell sub-units | Thickness of a support layer of a positive electrode current collector (μm) | Resistivity of a metal layer of the positive electrode current collector (*10⁻⁸ Ωm) | Thickness of the metal layer of the positive electrode current collector (μm) | Coating weight of an electrode sheet (g/1540 mm²) | Content of a binder in the electrode sheet (% by weight) | Compaction density of the electrode sheet (g/cm³) | Thickness of a separator (μm) | DCR (mΩ) | 2C rate - capacity retention rate | Capacity (Ah) | Whether it passed a low-speed nail penetration test | Whether it passed a high-speed nail penetration test | Nail penetration short-circuit resistance (mΩ) |
|---|---|---|---|---|---|---|---|---|---|---|---|---|---|---|
| Comparative Example 11-1 | 3 | 6/10/6 | 3.9/4.4/3.9 | 1.0/0.8/1.0 | 0.32/0.27/0.32 | 1.7%/1.7%/1.7% | 3.5/3.3/3.5 | 7/12/7 | 1.55 | 93.1% | 62.3 | Yes | No | 15.1/17.3/15.1 |
| Comparative Example 11-2 | 3 | 6/10/6 | 3.9/4.4/3.9 | 1.0/0.8/1.0 | 0.32/0.27/0.32 | 3.1%/1%/3.1% | 3.5/3.3/3.5 | 7/12/7 | 1.67 | 92.2% | 61.5 | Yes | No | 16.1/16.8/16.1 |
| Example 11 | 3 | 6/10/6 | 3.9/4.4/3.9 | 1.0/0.8/1.0 | 0.32/0.27/0.32 | 1%/3.1%/1% | 3.5/3.3/3.5 | 7/12/7 | 1.55 | 93.2% | 62.3 | Yes | Yes | 14.6/18.9/14.6 |
| Comparative Example 12-1 | 5 | 6/8/10/8/6 | 3.7/4.1/4.3/4.1/3.7 | 1.1/0.9/0.8/0.9/1.1 | 0.32/0.28/0.27/0.28/0.32 | 2%/2%/2%/2%/2% | 3.5/3.4/3.3/3.4/3.5 | 7/9/12/9/7 | 1.59 | 92.7% | 62.0 | Yes | No | 23.6/28.2/31.7/28.2/23.6 |
| Comparative Example 12-2 | 5 | 6/8/10/8/6 | 3.7/4.1/4.3/4.1/3.7 | 1.1/0.9/0.8/0.9/1.1 | 0.32/0.28/0.27/0.28/0.32 | 4%/2%/1%/2%/4% | 3.5/3.4/3.3/3.4/3.5 | 7/9/12/9/7 | 1.75 | 91.1% | 60.4 | Yes | No | 24.3/28.2/30.7/28.2/24.3 |
| Example 12 | 5 | 6/8/10/8/6 | 3.7/4.1/4.3/4.1/3.7 | 1.1/0.9/0.8/0.9/1.1 | 0.32/0.28/0.27/0.28/0.32 | 1%/2%/4%/2%/1% | 3.5/3.4/3.3/3.4/3.5 | 7/9/12/9/7 | 1.58 | 92.7% | 62.0 | Yes | Yes | 23.1/28.2/33.8/28.2/23.1 |

According to Table 6 above, it can be seen that compared with Comparative Example 11-1 which adopts the structure in which the binder in the electrode sheet of the battery cell sub-unit of the intermediate portion has a content equal to that of the binder in the electrode sheet of the battery cell sub-unit of the side portion, Example 11 which adopts the structure in which the binder in the electrode sheet of the battery cell sub-unit of the intermediate portion has a content greater than that of the binder in the electrode sheet of the battery cell sub-unit of the side portion can pass the low-speed and high-speed nail penetration tests while maintaining basically the same DCR, 2C rate-capacity retention rate and capacity of the battery cell, whereas Comparative Example 11-1 can only pass the low-speed nail penetration test but cannot pass the high-speed nail penetration test.

In addition, compared with Comparative Example 11-2 which adopts the structure in which the binder in the electrode sheet of the battery cell sub-unit of the intermediate portion has a content smaller than that of the binder in the electrode sheet of the battery cell sub-unit of the side portion, Example 11 which adopts the structure in which the binder in the electrode sheet of the battery cell sub-unit of the intermediate portion has a content greater than that of the binder in the electrode sheet of the battery cell sub-unit of the side portion can obtain a smaller DCR, a higher 2C rate-capacity retention rate and a greater capacity of the battery cell, and Example 11 can pass the low-speed and high-speed nail penetration tests, whereas Comparative Example 11-2 can only pass the low-speed nail penetration test but cannot pass the high-speed nail penetration test. That is to say, Example 11 can improve the safety of the battery cell without reducing the performance of the battery cell such as the energy density and the rate performance.

In addition, compared with Comparative Example 12-1 which adopts the structure in which the binder in the electrode sheet of the battery cell sub-unit of the intermediate portion has a content equal to that of the binder in the electrode sheet of the battery cell sub-unit of the side portion, Example 12 which adopts the structure in which the binder in the electrode sheet of the battery cell sub-unit of the intermediate portion has a content greater than that of the binder in the electrode sheet of the battery cell sub-unit of the side portion can pass the low-speed and high-speed nail penetration tests while maintaining basically the same DCR, 2C rate-capacity retention rate and capacity of the battery cell, whereas Comparative Example 12-1 can only pass the low-speed nail penetration test but cannot pass the high-speed nail penetration test.

In addition, compared with Comparative Example 12-2 which adopts the structure in which the binder in the electrode sheet of the battery cell sub-unit of the intermediate portion has a content smaller than that of the binder in the electrode sheet of the battery cell sub-unit of the side portion, Example 12 which adopts the structure in which the binder in the electrode sheet of the battery cell sub-unit of the intermediate portion has a content greater than that of the binder in the electrode sheet of the battery cell sub-unit of the side portion can obtain a smaller DCR, a higher 2C rate-capacity retention rate and a greater capacity of the battery cell, and Example 12 can pass the low-speed and high-speed nail penetration tests, whereas Comparative Example 12-2 can only pass the low-speed nail penetration test but cannot pass the high-speed nail penetration test. That is to say, Example 12 can improve the safety of the battery cell without reducing the performance of the battery cell such as the energy density and the rate performance.

<Design of the compaction density of an electrode sheet of a battery cell sub-unit in a battery cell>

Through the above method of [Preparation of battery cell], and by adjusting the thickness of the support layer of the positive electrode current collector, the resistivity of the metal layer of the positive electrode current collector, the thickness of the metal layer of the positive electrode current collector, the coating weight of the electrode sheet, the content of the binder in the electrode sheet, the compaction density of the electrode sheet, and the thickness of the separator for the battery cell sub-unit of the intermediate portion and the battery cell sub-units of the side portions, battery cells of Examples 13 and 14 below and battery cells of Comparative Examples 13-1, 13-2, 14-1 and 14-2 can be obtained. In Example 13, the battery cell includes three battery cell sub-units, and in Example 14, the battery cell includes five battery cell sub-units. A structure in which the electrode sheet of the battery cell sub-unit of the intermediate portion has a compaction density smaller than that of the electrode sheet of the battery cell sub-unit of the side portion is adopted in each of Examples 13 and 14.

In Comparative Examples 13-1 and 13-2, the battery cell includes three battery cell sub-units, and in Comparative Examples 14-1 and 14-2, the battery cell includes five battery cell sub-units. In Comparative Examples 13-1 and 14-1, the electrode sheet of the battery cell sub-unit of the intermediate portion has a compaction density equal to that of the electrode sheet of the battery cell sub-unit of the side portion, and in Comparative Examples 13-2 and 14-2, the electrode sheet of the battery cell sub-unit of the intermediate portion has a compaction density greater than that of the electrode sheet of the battery cell sub-unit of the side portion.

By testing Examples 13 and 14 and Comparative Examples 13-1, 13-2, 14-1 and 14-2, Table 7 below can be obtained, which shows the results of comparison between Examples 13 and 14 and Comparative Examples 13-1, 13-2, 14-1 and 14-2.

Table 7

| Table 7 | Number of battery cell sub-units | Thickness of a support layer of a positive electrode current collector (μm) | Resistivity of a metal layer of the positive electrode current collector ($*10^{-8}$ Ωm) | Thickness of the metal layer of the positive electrode current collector (μm) | Coating weight of an electrode sheet (g/1540 mm²) | Content of a binder in the electrode sheet (% by weight) | Compaction density of the electrode sheet (g/cm³) | Thickness of a separator (μm) | DCR (mΩ) | 2C rate - capacity retention rate | Capacity (Ah) | Whether it passed a low-speed nail penetration test | Whether it passed a high-speed nail penetration test | Nail penetration short-circuit resistance (mΩ) |
|---|---|---|---|---|---|---|---|---|---|---|---|---|---|---|
| Comparative Example 13-1 | 3 | 6/10/6 | 3.9/4.4/3.9 | 1.0/0.8/1.0 | 0.32/0.27/0.32 | 1%/2.5%/1% | 3.35/3.35/3.35 | 7/12/7 | 1.55 | 93.2% | 62.3 | Yes | No | 15.0/17.2/15.0 |
| Comparative Example 13-2 | 3 | 6/10/6 | 3.9/4.4/3.9 | 1.0/0.8/1.0 | 0.32/0.27/0.32 | 1%/2.5%/1% | 3.05/3.5/3.05 | 7/12/7 | 1.57 | 93.0% | 62.0 | Yes | No | 16.0/16.6/16.0 |
| Example 13 | 3 | 6/10/6 | 3.9/4.4/3.9 | 1.0/0.8/1.0 | 0.32/0.27/0.32 | 1%/2.5%/1% | 3.5/3.05/3.5 | 7/12/7 | 1.54 | 93.2% | 62.3 | Yes | Yes | 14.5/18.7/14.5 |
| Comparative Example 14-1 | 5 | 6/8/10/8/6 | 3.7/4.1/4.3/4.1/3.7 | 1.1/0.9/0.8/0.9/1.1 | 0.32/0.28/0.27/0.28/0.32 | 1%/2%/3%/2%/1 % | 3.36/3.36/3.36/3.36/3.36 | 7/9/12/9/7 | 1.54 | 93.4% | 62.5 | Yes | No | 23.5/28.3/31.6/28.3/23.5 |
| Comparative Example 14-2 | 5 | 6/8/10/8/6 | 3.7/4.1/4.3/4.1/3.7 | 1.1/0.9/0.8/0.9/1.1 | 0.32/0.28/0.27/0.28/0.32 | 1%/2%/3%/2%/1 % | 3.0/3.4/3.5/3.4/3.0 | 7/9/12/9/7 | 1.56 | 93.1% | 62.1 | Yes | No | 24.2/28.2/31.1/28.2/24.2 |
| Example 14 | 5 | 6/8/10/8/6 | 3.7/4.1/4.3/4.1/3.7 | 1.1/0.9/0.8/0.9/1.1 | 0.32/0.28/0.27/0.28/0.32 | 1%/2%/3%/2%/1 % | 3.5/3.4/3.0/3.4/3.5 | 7/9/12/9/7 | 1.54 | 93.5% | 62.5 | Yes | Yes | 23.2/28.2/33.2/28.2/23.2 |

According to Table 7 above, it can be seen that compared with Comparative Example 13-1 which adopts the structure in which the electrode sheet of the battery cell sub-unit of the intermediate portion has a compaction density equal to that of the electrode sheet of the battery cell sub-unit of the side portion, Example 13 which adopts the structure in which the electrode sheet of the battery cell sub-unit of the intermediate portion has a compaction density smaller than that of the electrode sheet of the battery cell sub-unit of the side portion can pass the low-speed and high-speed nail penetration tests while maintaining basically the same DCR, 2C rate-capacity retention rate and capacity of the battery cell, whereas Comparative Example 13-1 can only pass the low-speed nail penetration test but cannot pass the high-speed nail penetration test.

In addition, compared with Comparative Example 13-2 which adopts the structure in which the electrode sheet of the battery cell sub-unit of the intermediate portion has a compaction density greater than that of the electrode sheet of the battery cell sub-unit of the side portion, Example 13 which adopts the structure in which the electrode sheet of the battery cell sub-unit of the intermediate portion has a compaction density smaller than that of the electrode sheet of the battery cell sub-unit of the side portion can obtain a smaller DCR, a higher 2C rate-capacity retention rate and a greater capacity of the battery cell, and Example 13 can pass the low-speed and high-speed nail penetration tests, whereas Comparative Example 13-2 can only pass the low-speed nail penetration test but cannot pass the high-speed nail penetration test. That is to say, Example 13 can improve the safety of the battery cell without reducing the performance of the battery cell such as the energy density and the rate performance.

In addition, compared with Comparative Example 14-1 which adopts the structure in which the electrode sheet of the battery cell sub-unit of the intermediate portion has a compaction density equal to that of the electrode sheet of the battery cell sub-unit of the side portion, Example 14 which adopts the structure in which the electrode sheet of the battery cell sub-unit of the intermediate portion has a compaction density smaller than that of the electrode sheet of the battery cell sub-unit of the side portion can pass the low-speed and high-speed nail penetration tests while maintaining basically the same DCR, 2C rate-capacity retention rate and capacity of the battery cell, whereas Comparative Example 14-1 can only pass the low-speed nail penetration test but cannot pass the high-speed nail penetration test.

In addition, compared with Comparative Example 14-2 which adopts the structure in which the electrode sheet of the battery cell sub-unit of the intermediate portion has a compaction density greater than that of the electrode sheet of the battery cell sub-unit of the side portion, Example 14 which adopts the structure in which the electrode sheet of the battery cell sub-unit of the intermediate portion has a compaction density smaller than that of the electrode sheet of the battery cell sub-unit of the side portion can obtain a smaller DCR, a higher 2C rate-capacity retention rate and a greater capacity of the battery cell, and Example 14 can pass the low-speed and high-speed nail penetration tests, whereas Comparative Example 14-2 can only pass the low-speed nail penetration test but cannot pass the high-speed nail penetration test. That is to say, Example 14 can improve the safety of the battery cell without reducing the performance of the battery cell such as the energy density and the rate performance.

<Design of the thickness of a separator of a battery cell sub-unit in a battery cell>

Through the above method of [Preparation of battery cell], and by adjusting the thickness of the support layer of the positive electrode current collector, the resistivity of the metal layer of the positive electrode current collector, the thickness of the metal layer of the positive electrode current collector, the coating weight of the electrode sheet, the content of the binder in the electrode sheet, the compaction density of the electrode sheet, and the thickness of the separator for the battery cell sub-unit of the intermediate portion and the battery cell sub-units of the side portions, battery cells of Examples 15 and 16 below and battery cells of Comparative Examples 15-1, 15-2, 16-1 and 16-2 can be obtained. In Example 15, the battery cell includes three battery cell sub-units, and in Example 16, the battery cell includes five battery cell sub-units. A structure in which the separator of the battery cell sub-unit of the intermediate portion has a thickness greater than that of the separator of the battery cell sub-unit of the side portion is adopted in each of Examples 15 and 16.

In Comparative Examples 15-1 and 15-2, the battery cell includes three battery cell sub-units, and in Comparative Examples 16-1 and 16-2, the battery cell includes five battery cell sub-units. In Comparative Examples 15-1 and 16-1, the separator of the battery cell sub-unit of the intermediate portion has a thickness equal to that of the separator of the battery cell sub-unit of the side portion, and in Comparative Examples 15-2 and 16-2, the separator of the battery cell sub-unit of the intermediate portion has a thickness smaller than that of the separator of the battery cell sub-unit of the side portion.

By testing Examples 15 and 16 and Comparative Examples 15-1, 15-2, 16-1 and 16-2, Table 8 below can be obtained, which shows the results of comparison between Examples 15 and 16 and Comparative Examples 15-1, 15-2, 16-1 and 16-2.

Table 8

| Table 8 | Number of battery cell sub-units | Thickness of a support layer of a positive electrode current collector ($\mu$m) | Resistivity of a metal layer of the positive electrode current collector ($*10^{-8}$ $\Omega$m) | Thickness of the metal layer of the positive electrode current collector ($\mu$m) | Coating weight of an electrode sheet (g/1540 mm$^2$) | Content of a binder in the electrode sheet (% by weight) | Compaction density of the electrode sheet (g/cm$^3$) | Thickness of a separator ($\mu$m) | DCR (m$\Omega$) | 2C rate - capacity retention rate | Capacity (Ah) | Whether it passed a low-speed nail penetration test | Whether it passed a high-speed nail penetration test | Nail penetration short-circuit resistance (m$\Omega$) |
|---|---|---|---|---|---|---|---|---|---|---|---|---|---|---|
| Comparative Example 15-1 | 3 | 6/10/6 | 3.9/4.4/3.9 | 1.0/0.8/1.0 | 0.32/0.27/0.32 | 1%/2.5%/1% | 3.5/3.3/3.5 | 9/9/9 | 1.55 | 93.3% | 62.3 | Yes | No | 15.1/17.5/15.1 |
| Comparative Example 15-2 | 3 | 6/10/6 | 3.9/4.4/3.9 | 1.0/0.8/1.0 | 0.32/0.27/0.32 | 1%/2.5%/1% | 3.5/3.3/3.5 | 13/7/13 | 1.56 | 92.7% | 61.8 | Yes | No | 15.7/17.0/15.7 |
| Example 15 | 3 | 6/10/6 | 3.9/4.4/3.9 | 1.0/0.8/1.0 | 0.32/0.27/0.32 | 1%/2.5%/1% | 3.5/3.3/3.5 | 7/13/7 | 1.55 | 93.4% | 62.3 | Yes | Yes | 14.8/18.5/14.8 |
| Comparative Example 16-1 | 5 | 6/8/10/8/6 | 3.7/4.1/4.3/4.1/3.7 | 1.1/0.9/0.8/0.9/1.1 | 0.32/0.28/0.27/0.28/0.32 | 1%/2%/3%/2%/1% | 3.5/3.4/3.313.413.5 | 919191919 | 1.55 | 93.2% | 62.5 | Yes | No | 23.8/28.2/32.1/28.2/23.8 |
| Comparative Example 16-2 | 5 | 6/8/10/8/6 | 3.7/4.1/4.3/4.1/3.7 | 1.1/0.9/0.8/0.9/1.1 | 0.32/0.28/0.27/0.28/0.32 | 1%/2%/3%/2%/1% | 3.5/3.4/3.313.413.5 | 13/9/7/9/1 3 | 1.56 | 92.7% | 62.0 | Yes | No | 24.1/28.2/31.4/28.2/24.1 |
| Example 16 | 5 | 6/8/10/8/6 | 3.7/4.1/4.3/4.1/3.7 | 1.1/0.9/0.8/0.9/1.1 | 0.32/0.28/0.27/0.28/0.32 | 1%/2%/3%/2%/1% | 3.5/3.4/3.3/3.4/3.5 | 7/9/13/9/7 | 1.54 | 93.2% | 62.5 | Yes | Yes | 23.2/28.2/33.5/28.2/23.2 |

According to Table 8 above, it can be seen that compared with Comparative Example 15-1 which adopts the structure in which the separator of the battery cell sub-unit of the intermediate portion has a thickness equal to that of the separator of the battery cell sub-unit of the side portion, Example 15 which adopts the structure in which the separator of the battery cell sub-unit of the intermediate portion has a thickness greater than that of the separator of the battery cell sub-unit of the side portion can pass the low-speed and high-speed nail penetration tests while maintaining basically the same DCR, 2C rate-capacity retention rate and capacity of the battery cell, whereas Comparative Example 15-1 can only pass the low-speed nail penetration test but cannot pass the high-speed nail penetration test.

In addition, compared with Comparative Example 15-2 which adopts the structure in which the separator of the battery cell sub-unit of the intermediate portion has a thickness smaller than that of the separator of the battery cell sub-unit of the side portion, Example 15 which adopts the structure in which the separator of the battery cell sub-unit of the intermediate portion has a thickness greater than that of the separator of the battery cell sub-unit of the side portion can obtain a smaller DCR, a higher 2C rate-capacity retention rate and a greater capacity of the battery cell, and Example 15 can pass the low-speed and high-speed nail penetration tests, whereas Comparative Example 15-2 can only pass the low-speed nail penetration test but cannot pass the high-speed nail penetration test. That is to say, Example 15 can improve the safety of the battery cell without reducing the performance of the battery cell such as the energy density and the rate performance.

In addition, compared with Comparative Example 16-1 which adopts the structure in which the separator of the battery cell sub-unit of the intermediate portion has a thickness equal to that of the separator of the battery cell sub-unit of the side portion, Example 16 which adopts the structure in which the separator of the battery cell sub-unit of the intermediate portion has a thickness greater than that of the separator of the battery cell sub-unit of the side portion can pass the low-speed and high-speed nail penetration tests while maintaining basically the same DCR, 2C rate-capacity retention rate and capacity of the battery cell, whereas Comparative Example 16-1 can only pass the low-speed nail penetration test but cannot pass the high-speed nail penetration test.

In addition, compared with Comparative Example 16-2 which adopts the structure in which the separator of the battery cell sub-unit of the intermediate portion has a thickness smaller than that of the separator of the battery cell sub-unit of the side portion, Example 16 which adopts the structure in which the separator of the battery cell sub-unit of the intermediate portion has a thickness greater than that of the separator of the battery cell sub-unit of the side portion can obtain a smaller DCR, a higher 2C rate-capacity retention rate and a greater capacity of the battery cell, and Example 16 can pass the low-speed and high-speed nail penetration tests, whereas Comparative Example 16-2 can only pass the low-speed nail penetration test but cannot pass the high-speed nail penetration test. That is to say, Example 16 can improve the safety of the battery cell without reducing the performance of the battery cell such as the energy density and the rate performance.

In addition, in Tables 1 to 8 above, the electrode sheet in the expressions "the coating weight of the electrode sheet", "the content of the binder in the electrode sheet", and "the compaction density of the electrode sheet" may be a positive electrode sheet, or a negative electrode sheet.

<Design of the content of a silicon-based material and the elastic modulus of a binder in the case where A battery cell sub-units of a high expansion system and B battery cell sub-units of a low expansion system are alternately arranged>

Through the above method of [Preparation of battery cell], and by adopting the following different steps, battery cells of Examples 17 and 18 and battery cells of Comparative Examples 17-1 and 18-1 can be obtained. The different steps mentioned above are as follows:

Two kinds of polystyrene-butadiene copolymers (SBR) with elastic moduli are used, respectively, and different contents of silicon-containing negative electrode materials (SiO) are added to prepare negative electrode slurries. Specifically, the method for preparing a negative electrode sheet of the low expansion system (including the B battery cell sub-unit) is as follows: graphite and silicon monoxide (SiO), conductive carbon, a binder polystyrene-butadiene copolymer (SBR) (with an elastic modulus of 15 Mpa) and a thickener sodium carboxymethyl cellulose (CMC) are respectively at the weight ratios of 89.2:7:0.8:1.8:1.2 and 92.2:4:0.8:1.8:1.2, to obtain two negative electrode slurries with different silicon content formulas. The negative electrode slurries are cold-pressed, die-cut, and slitted to make two negative electrode sheets, namely a first negative electrode sheet and a second negative electrode sheet. The first negative electrode sheet is the negative electrode sheet of Comparative Examples 17-1 and 18-1, and the second negative electrode sheet is the negative electrode sheet of the B battery cell sub-unit of the examples. The method for preparing a negative electrode sheet of the high expansion system (i.e., the A battery cell sub-unit) is as follows: graphite and silicon monoxide (SiO), conductive carbon, a binder polystyrene-butadiene copolymer (SBR) (with an elastic modulus of 30 Mpa) and a thickener sodium carboxymethyl cellulose (CMC) are at the weight ratio of 81.2:15:0.8:1.8:1.2, to obtain a negative electrode slurry. The negative electrode slurry is cold-pressed, die-cut, and slitted to make a negative electrode sheet of the A battery cell sub-unit. The first negative electrode sheet is wound with the positive electrode sheet, hot-pressed, assembled, chemically formed, capacity graded, and encapsulated to obtain the battery cells of Comparative Examples17-1 and 18-1, which have three and five battery cell sub-units. The second negative electrode sheet (i.e., the negative electrode sheet of the B battery cell sub-unit) and the negative electrode sheet of the A battery cell sub-unit are respectively wound with the positive electrode sheet, hot-pressed, assembled, formed, capacity graded, and encapsulated to obtain the battery cells in Examples 17 and 18, which have three and five battery cell sub-units.

In Example 17, the battery cell includes three battery cell sub-units, and in Example 18, the battery cell includes five battery cell sub-units. A structure in which A battery cell sub-units of the system with a large cyclic expansion force and B battery cell sub-units of the system with a small cyclic expansion force are alternately arranged is adopted in each of Examples 17 and 18. Specifically, in Examples 17 and 18, in the A battery cell sub-unit of the system with a large cyclic expansion force, the content of the silicon-based material is large, and the elastic modulus of the binder is large.

In Comparative Example 17-1, the battery cell includes three battery cell sub-units, and in Comparative Example 18-1, the battery cell includes five battery cell sub-units, but each battery cell sub-unit in Comparative Examples 17-1 and 18-1 has the same cyclic expansion force. Specifically, in Comparative Examples 17-1 and 18-1, each battery cell sub-unit has the same content of the silicon-based material and the same elastic modulus of the binder.

In addition, in Examples 17 and 18 and Comparative Examples 17-1 and 18-1, it is satisfied that the battery cell sub-unit of the intermediate portion has a dry battery cell nail penetration short-circuit resistance greater than that of the battery cell sub-unit of the side portion, so that the examples all can pass the low-speed nail penetration test.

By testing Examples 17 and 18 and Comparative Examples 17-1 and 18-1, Table 9 below can be obtained, which shows the results of comparison between Examples 17 and 18 and Comparative Examples 17-1 and 18-1.

Table 9

| Table 9 | Number of battery cell sub-units | Content of a silic on-based material (wt%) | Elastic modulu s of a binder ( MPa) | Thickness of a battery cell sub -unit (mm) | Expansion force at 60°C for 200 cycles (kgF) | Whether an electrode sheet of an inner ring is broken | Cell Ca pacity ( Ah) | Cycles at 60°C with 80% decay | Whether an e lectrode sheet is wrinkled |
|---|---|---|---|---|---|---|---|---|---|
| Comparative Example 17-1 | 3 | 7%/7%/7 % | 15/15/15 | 8.6/8.6/8.6 | 1082 | Yes | 67.8 | 374 | Yes |
| Example 17 | 3 | 4%/15%/ 4% | 15/30/15 | 8.6/8.6/8.6 | 935 | No | 68.5 | 381 | No |
| Comparative Example 18-1 | 5 | 7%/7%/7 %/ 7%/7 % | 15/15/15/15/15 | 5.16/5.16/5.16/ 5.16/5.16 | 1078 | Yes | 67.7 | 374 | Yes |
| Example 18 | 5 | 4%/15%/ 4%/ 15%/ 4% | 15/30/15/30/15 | 5.16/5.16/5.16/ 5.16/5.16 | 928 | No | 68.7 | 383 | No |

According to Table 9 above, it can be seen that in Comparative Examples 17-1 and 18-1, since each battery cell sub-unit has the same content of the silicon-based material and the same elastic modulus of the binder, the electrode sheet of the inner ring is broken. In addition, the electrode sheet is wrinkled, the expansion force at 60°C for 200 cycles is large, the capacity of the battery cell is small, and the number of cycles corresponding to the capacity decaying to 80% when cycling at 60°C is small. In addition, the reason for the wrinkling is that the electrode sheet expands after many cycles of the battery cell, the deformation is large, and the stress cannot be released, so that the electrode sheet will have a wrinkling problem caused by excessive expansion.

In Examples 17 and 18 of the present application, the elastic modulus of the binder of the A battery cell sub-unit with a higher content of silicon-based material is larger, so that the electrode sheets of the inner rings of the battery cells of Examples 17 and 18 are not broken, and the electrode sheets are not wrinkled; and the expansion force at 60°C for 200 cycles is smaller, the capacity of the battery cell is larger, and the number of cycles corresponding to the capacity decaying to 80% when cycling at 60°C is greater compared with Comparative Examples 17-1 and 18-1. That is, in Examples 17 and 18 of the present application, the overall cyclic expansion force of the battery cell can be reduced, and can also improve the performance of the battery cell such as the energy density and the cycle life.

<Design of the thickness of a battery cell sub-unit in the case where A battery cell sub-units of a high expansion system and B battery cell sub-units of a low expansion system are alternately arranged>

Through the above method of [Preparation of battery cell], and by adopting the following different steps, battery cells of Examples 19 and 20 and battery cells of Comparative Examples 19-1 and 20-1 can be obtained. The different steps mentioned above are as follows:

Different contents of silicon-containing negative electrode material (SiO) are added to prepare negative electrode slurries, and the thicknesses of battery cell sub-units are not all the same. Specifically, the method for preparing a negative electrode sheet of the low expansion system (including the B battery cell sub-unit) is as follows: graphite and silicon monoxide (SiO), conductive carbon, a binder polystyrene-butadiene copolymer (SBR) (with an elastic modulus of 15 Mpa) and a thickener sodium carboxymethyl cellulose (CMC) are respectively at the weight ratios of 90.2:6:0.8:1.8:1.2, 91.2:5:0.8:1.8:1.2 and 91.2:4:0.8:1.8:1.2, to obtain three negative electrode slurries with different silicon content formulas. The negative electrode slurries are cold-pressed, die-cut, and slitted to make three negative electrode sheets, namely a first negative electrode sheet, a second negative electrode sheet and a third negative electrode sheet. The first negative electrode sheet is the negative electrode sheet of Comparative Examples 19-1 and 20-1, the second negative electrode sheet is the negative electrode sheet of the B battery cell sub-unit of Example 19, and the third negative electrode sheet is the negative electrode sheet of the B battery cell sub-unit of Example 20. The method for preparing a negative electrode sheet of the high expansion system (i.e., the A battery cell sub-unit of Examples 19 and 20) is as follows: graphite and silicon monoxide (SiO), conductive carbon, a binder polystyrene-butadiene copolymer (SBR) (with an elastic modulus of 15 Mpa) and a thickener sodium carboxymethyl cellulose (CMC) are respectively at the weight ratios of 82.2:14:0.8:1.8:1.2 and 85.9:10.3:0.8:1.8:1.2, to obtain two negative electrode slurries. The negative electrode slurries are cold-pressed, die-cut, and slitted to make two negative electrode sheets, namely a fourth negative electrode sheet and a fifth negative electrode sheet. The fourth negative electrode sheet is the negative electrode sheet of the A battery cell sub-unit of Example 19, and the fifth negative electrode sheet is the negative electrode sheet of the A battery cell sub-unit of Example 20. The first negative electrode sheet is wound with the positive electrode sheet (a test winding thickness is first determined during the winding process), hot-pressed, assembled, chemically formed, capacity graded, and encapsulated to obtain the battery cells of Comparative Examples 19-1 and 20-1, which have three and five battery cell sub-units. The second and fourth negative electrode sheets are respectively wound with the positive electrode sheet (a test winding thickness is first determined during the winding process), hot-pressed, assembled, chemically formed, capacity graded, and encapsulated to obtain the battery cells of Example 19, which have three and five battery cell sub-units. The third and fifth negative electrode sheet are respectively wound with the positive electrode sheet (a test winding thickness is first determined during the winding process), hot-pressed, assembled, chemically formed, capacity graded, and encapsulated to obtain the battery cells of Example 20, which have three and five battery cell sub-units.

In Example 19, the battery cell includes three battery cell sub-units, and in Example 20, the battery cell includes five battery cell sub-units. A structure in which A battery cell sub-units of the system with a large cyclic expansion force and B battery cell sub-units of the system with a small cyclic expansion force are alternately arranged is adopted in each of Examples 19 and 20. Specifically, in Examples 19 and 20, in the A battery cell sub-unit of the system with a large cyclic expansion force, the content of the silicon-based material is large, and the thickness of the battery cell sub-unit is small.

In Comparative Example 19-1, the battery cell includes three battery cell sub-units, and in Comparative Example 20-1, the battery cell includes five battery cell sub-units, but each battery cell sub-unit in Comparative Examples 19-1 and 20-1 has the same cyclic expansion force. Specifically, in Comparative Examples 19-1 and 20-1, each battery cell sub-unit has the same content of the silicon-based material and the same thickness of the battery cell sub-unit.

In addition, in Examples 19 and 20 and Comparative Examples 19-1 and 20-1, it is satisfied that the battery cell sub-unit of the intermediate portion has a dry battery cell nail penetration short-circuit resistance greater than that of the battery cell sub-unit of the side portion, so that the examples all can pass the low-speed nail penetration test.

By testing Examples 19 and 20 and Comparative Examples 19-1 and 20-1, Table 10 below can be obtained, which shows the results of comparison between Examples 19 and 20 and Comparative Examples 19-1 and 20-1.

Table 10

| Table 10 | Number of batter y cell su b-units | Content of a silicon-ba sed materia l (wt%) | Elastic modulus of a binder (MP a) | Thickness of a battery cell sub-unit (mm) | Expansion forc e at 60°C for 2 00 cycles (kgF ) | Whether an e lectrode sheet of an inner ri ng is broken | Cell Ca pacity ( Ah) | Cycles at 60°C with 80% decay | Whether an electr ode sheet is wrinkl ed |
|---|---|---|---|---|---|---|---|---|---|
| Comparative Example 19-1 | 3 | 6%/6%/6% | 15/15/15 | 8.6/8.6/8.6 | 867 | Yes | 66.8 | 379 | Yes |
| Example 19 | 3 | 5%/14%/5 % | 15/15/15 | 9.4/4.5/9.4 | 795 | No | 67.6 | 387 | No |
| Comparative Example 20-1 | 5 | 6%/6%/6%/ 6%/6% | 15/15/15 | 5.16/5.16/5.16/5.16/5. 16 | 865 | Yes | 66.8 | 380 | Yes |
| Example 20 | 5 | 4%/10.3%/ 4%/10.3%/ 4% | 15/15/15 | 5.8/4.2/5.8/4.2/5.8 | 791 | No | 67.6 | 389 | No |

According to Table 10 above, it can be seen that in Comparative Examples 19-1 and 20-1, since each battery cell sub-unit has the same content of the silicon-based material and the same thickness of the battery cell sub-unit, the electrode sheet of the inner ring is broken. In addition, the electrode sheet is wrinkled, the expansion force at 60°C for 200 cycles is large, the capacity of the battery cell is small, and the number of cycles corresponding to the capacity decaying to 80% when cycling at 60°C is small.

In Examples 19 and 20 of the present application, the A battery cell sub-unit with a higher content of silicon-based material has a smaller thickness, so that the electrode sheets of the inner rings of the battery cells of Examples 19 and 20 are not broken, and the electrode sheets are not wrinkled; and the expansion force at 60°C for 200 cycles is smaller, the capacity of the battery cell is larger, and the number of cycles corresponding to the capacity decaying to 80% when cycling at 60°C is greater compared with Comparative Examples 19-1 and 20-1. That is, in Examples 19 and 20 of the present application, the overall cyclic expansion force of the battery cell can be reduced, and can also improve the performance of the battery cell such as the energy density and the cycle life.

The various examples or embodiments in the description are described in a progressive manner, each example focuses on the differences from other examples, and the same and similar parts of the various examples can be referred to each other.

In the description, the explanation with reference to the terms such as "an embodiment", "some embodiments", "exemplary embodiments", "examples", "specific examples", or "some examples" means that specific features, structures, materials, or characteristics described in combination with the embodiment(s) or example(s) are included in at least one embodiment or example of the present application. In the description, the illustrative expressions of the above-mentioned terms are not necessarily referring to the same embodiment or example. Moreover, the specific features, structures, materials, or characteristics described herein may be combined in any one or more embodiments or examples in a suitable manner.

Finally, it should be noted that the above examples are merely used for illustrating rather than limiting the technical solutions of the present application. Although the present application has been described in detail with reference to the above examples, those of ordinary skill in the art should understood that the technical solutions specified in the above various examples can still be modified, or some or all of the technical features therein can be equivalently substituted; and such modifications or substitutions do not make the essence of the corresponding technical solutions depart from the scope of the technical solutions of the various examples of the present application.

## Claims

1. A battery cell, comprising an intermediate portion and side portions located on two sides of the intermediate portion in a thickness direction, the intermediate portion comprising m battery cell sub-units and the side portions comprising n battery cell sub-units, m+n being an integer greater than or equal to 3, wherein

   each of the battery cell sub-units comprises a positive electrode sheet, a negative electrode sheet and a separator arranged between the positive electrode sheet and the negative electrode sheet, and
   each of the m battery cell sub-units has a dry battery cell nail penetration short-circuit resistance greater than that of each of the n battery cell sub-units.

2. The battery cell of claim 1, wherein
   the intermediate portion has a thickness accounting for 20% to 40% of the total thickness of the battery cell.

3. The battery cell of claim 1 or 2, wherein

   the positive electrode sheet comprises a positive electrode current collector, the positive electrode current collector comprising a support layer and a metal layer, and
   the support layer of the positive electrode current collector of each of the m battery cell sub-units has a thickness greater than that of the support layer of the positive electrode current collector of each of the n battery cell sub-units.

4. The battery cell of claim 3, wherein

   the metal layer of the positive electrode current collector of each of the m battery cell sub-units has a resistivity greater than that of the metal layer of the positive electrode current collector of each of the n battery cell sub-units, optionally, the resistivity of the metal layer of the positive electrode current collector of each of the m battery cell sub-units is 1.05 to 1.5 times the resistivity of the metal layer of the positive electrode current collector of each of the n battery cell sub-units.

5. The battery cell of claim 3 or 4, wherein

the metal layer of the positive electrode current collector of each of the m battery cell sub-units has a thickness smaller than that of the metal layer of the positive electrode current collector of each of the n battery cell sub-units, optionally, the thickness of the metal layer of the positive electrode current collector of each of the m battery cell sub-units is 60% to 90% of the thickness of the metal layer of the positive electrode current collector of each of the n battery cell sub-units.

6. The battery cell of any one of claims 1 to 5, wherein

the positive electrode sheet of each of the m battery cell sub-units has a coating weight smaller than that of the positive electrode sheet of each of the n battery cell sub-units, optionally, the coating weight of the positive electrode sheet of each of the m battery cell sub-units is 70% to 90% of the coating weight of the positive electrode sheet of each of the n battery cell sub-units; and/or the negative electrode sheet of each of the m battery cell sub-units has a coating weight smaller than that of the negative electrode sheet of each of the n battery cell sub-units, optionally, the coating weight of the negative electrode sheet of each of the m battery cell sub-units is 70% to 90% of the coating weight of the negative electrode sheet of each of the n battery cell sub-units.

7. The battery cell of any one of claims 1 to 6, wherein

a binder in the positive electrode sheet of each of the m battery cell sub-units has a content greater than that of a binder in the positive electrode sheet of each of the n battery cell sub-units, optionally, the content of the binder in the positive electrode sheet of each of the m battery cell sub-units is 3% by weight to 4% by weight, and the content of the binder in the positive electrode sheet of each of the n battery cell sub-units is 1% by weight to 2% by weight; and/or a binder in the negative electrode sheet of each of the m battery cell sub-units has a content greater than that of a binder in the negative electrode sheet of each of the n battery cell sub-units, optionally, the content of the binder in the negative electrode sheet of each of the m battery cell sub-units is 3% by weight to 4% by weight, and the content of the binder in the negative electrode sheet of each of the n battery cell sub-units is 1% by weight to 2% by weight.

8. The battery cell of any one of claims 1 to 7, wherein

the positive electrode sheet of each of the m battery cell sub-units has a compaction density smaller than that of the positive electrode sheet of each of the n battery cell sub-units, optionally, the compaction density of the positive electrode sheet of each of the m battery cell sub-units is 80% to 98% of the compaction density of the positive electrode sheet of each of the n battery cell sub-units; and/or the negative electrode sheet of each of the m battery cell sub-units has a compaction density smaller than that of the negative electrode sheet of each of the n battery cell sub-units, optionally, the compaction density of the negative electrode sheet of each of the m battery cell sub-units is 80% to 98% of the compaction density of the negative electrode sheet of each of the n battery cell sub-units.

9. The battery cell of any one of claims 1 to 8, wherein

the separator of each of the m battery cell sub-units has a thickness greater than that of the separator of each of the n battery cell sub-units, optionally, the thickness of the separator of each of the m battery cell sub-units is 10 to 13 $\mu$m, and the thickness of the separator of each of the n battery cell sub-units is 7 to 9 $\mu$m.

10. The battery cell of any one of claims 1 to 9, wherein the total thickness of the battery cell and the total number m+n of the battery cell sub-units satisfy: the total thickness of the battery cell/(m+n) $\geq$ 5 mm.

11. The battery cell of any one of claims 1 to 10, wherein

the battery cell is constituted by an alternate arrangement of A battery cell sub-units and B battery cell sub-units,
the A battery cell sub-unit and the B battery cell sub-unit contain a silicon-based material as a negative electrode active material,
the content of the silicon-based material of the A battery cell sub-unit is 10% by weight or more, and
the content of the silicon-based material of the B battery cell sub-unit is less than 10% by weight.

12. The battery cell of claim 11, wherein
a binder in the A battery cell sub-unit has an elastic modulus greater than that of a binder in the B battery cell sub-unit.

13. The battery cell of claim 11 or 12, wherein
the A battery cell sub-unit and the B battery cell sub-unit are wound battery cells, and the A battery cell sub-unit has a thickness smaller than that of the B battery cell sub-unit.

14. A battery module, comprising the battery cell of any one of claims 1 to 13.

15. A battery pack, comprising the battery module of claim 14.

16. An electrical apparatus, comprising the battery module of claim 14 or the battery pack of claim 15, wherein the battery module or the battery pack is used as a power source or an energy storage unit of the electrical apparatus.

FIG. 1

Description of the side opposite to
a penetration direction

Description of the middle side

Description of the side along
the penetration direction

**FIG. 2A**

**FIG. 2B**

**FIG. 2C**

D1 D2 D3 D4 D5

**FIG. 3A**

**FIG. 3B**

Tabs welded together

ABABA

**FIG. 4A**

A
B
A
B
A

Tabs welded together

**FIG. 4B**

**5**

## FIG. 5A

**5**

53

52

52

51

## FIG. 5B

**FIG. 6**

1

**FIG. 7A**

1

**FIG. 7B**

FIG. 8

## INTERNATIONAL SEARCH REPORT

| International application No. |
|---|
| **PCT/CN2021/137152** |

| | |
|---|---|
| **A.** | **CLASSIFICATION OF SUBJECT MATTER** |
| | H01M 10/0585(2010.01)i |

According to International Patent Classification (IPC) or to both national classification and IPC

| | |
|---|---|
| **B.** | **FIELDS SEARCHED** |

Minimum documentation searched (classification system followed by classification symbols)

　　H01M

Documentation searched other than minimum documentation to the extent that such documents are included in the fields searched

Electronic data base consulted during the international search (name of data base and, where practicable, search terms used)

　　CNPAT, CNKI, WPI, EPODOC: 电池, 电芯, 中间, 中央, 中心, 侧, 端, 穿钉, 短路, 电阻, 集流体, 集电体, 支撑层, 金属层, 涂覆, 涂布, 粘结剂, 粘接剂, 压实密度, 隔膜, 硅, 膨胀力, 弹性模量, 卷, 电池组, 电池包, battery, cell, middle, center, side, end, staple, short, resistance, current, collector, support, layer, metal, coat+, binder, adhesive, compacted, density, separator, silicon, Si, expansion, force, elastic, modulu, roll+, pack

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| X | CN 108808112 A (TOYOTA MOTOR CORP.) 13 November 2018 (2018-11-13) description, paragraphs 0047-0052 and 0062-0065, and figures 2-5 | 1-2, 6-10, 14-16 |
| Y | CN 108808112 A (TOYOTA MOTOR CORP.) 13 November 2018 (2018-11-13) description, paragraphs 0047-0052 and 0062-0065, and figures 2-5 | 3-5, 11-13 |
| X | CN 108807828 A (TOYOTA MOTOR CORP.) 13 November 2018 (2018-11-13) description, paragraphs 0060-0064 and 0089-0092, and figures 2-5 | 1-2, 6-10, 14-16 |
| Y | CN 108807828 A (TOYOTA MOTOR CORP.) 13 November 2018 (2018-11-13) description, paragraphs 0060-0064 and 0089-0092, and figures 2-5 | 3-5, 11-13 |
| X | CN 108808097 A (TOYOTA MOTOR CORP.) 13 November 2018 (2018-11-13) description, paragraphs 0053-0057 and 0070-0073, and figures 2-5 | 1-2, 6-10, 14-16 |
| Y | CN 108808097 A (TOYOTA MOTOR CORP.) 13 November 2018 (2018-11-13) description, paragraphs 0053-0057 and 0070-0073, and figures 2-5 | 3-5, 11-13 |
| X | CN 108808111 A (TOYOTA MOTOR CORP.) 13 November 2018 (2018-11-13) description, paragraphs 0055-0059 and 0084-0087, and figures 2-5 | 1-2, 6-10, 14-16 |

☑ Further documents are listed in the continuation of Box C.     ☑ See patent family annex.

| | |
|---|---|
| * | Special categories of cited documents: |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **28 August 2022** | **07 September 2022** |

| Name and mailing address of the ISA/CN | Authorized officer |
|---|---|
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2021/137152** |

**C.      DOCUMENTS CONSIDERED TO BE RELEVANT**

| Category* | Citation of document, with indication, where appropriate, of the relevant passages | Relevant to claim No. |
| --- | --- | --- |
| Y | CN 108808111 A (TOYOTA MOTOR CORP.) 13 November 2018 (2018-11-13)<br>      description, paragraphs 0055-0059 and 0084-0087, and figures 2-5 | 3-5, 11-13 |
| Y | CN 112186195 A (NINGDE CONTEMPORARY AMPEREX TECHNOLOGY CO., LTD.)<br>05 January 2021 (2021-01-05)<br>      description, paragraphs 0005-0074, 0108-0115, and 0235-0254 | 3-5 |
| Y | CN 113594615 A (NINGDE CONTEMPORARY AMPEREX TECHNOLOGY CO., LTD.)<br>02 November 2021 (2021-11-02)<br>      description, paragraphs 0005-0032, 0044-0057, and 0087-0088 | 11-13 |

Form PCT/ISA/210 (second sheet) (January 2015)

International application No.

**PCT/CN2021/137152**

| Patent document cited in search report | | | Publication date (day/month/year) | Patent family member(s) | | | Publication date (day/month/year) |
|---|---|---|---|---|---|---|---|
| CN | 108808112 | A | 13 November 2018 | US | 2018316066 | A1 | 01 November 2018 |
|  |  |  |  | DE | 102018108136 | A1 | 31 October 2018 |
|  |  |  |  | KR | 20180121358 | A | 07 November 2018 |
|  |  |  |  | JP | 2018190529 | A | 29 November 2018 |
|  |  |  |  | KR | 102055546 | B1 | 13 December 2019 |
|  |  |  |  | JP | 6729479 | B2 | 22 July 2020 |
|  |  |  |  | US | 11075409 | B2 | 27 July 2021 |
|  |  |  |  | CN | 108808112 | B | 30 July 2021 |
| CN | 108807828 | A | 13 November 2018 | JP | 2018190534 | A | 29 November 2018 |
|  |  |  |  | US | 2018316065 | A1 | 01 November 2018 |
|  |  |  |  | JP | 6638693 | B2 | 29 January 2020 |
|  |  |  |  | US | 10910677 | B2 | 02 February 2021 |
|  |  |  |  | CN | 108807828 | B | 06 April 2021 |
| CN | 108808097 | A | 13 November 2018 | JP | 2018190531 | A | 29 November 2018 |
|  |  |  |  | US | 2018316048 | A1 | 01 November 2018 |
|  |  |  |  | CN | 108808097 | B | 17 September 2021 |
|  |  |  |  | US | 10559845 | B2 | 11 February 2020 |
|  |  |  |  | JP | 6638692 | B2 | 29 January 2020 |
| CN | 108808111 | A | 13 November 2018 | RU | 2679900 | C1 | 14 February 2019 |
|  |  |  |  | JP | 2018190530 | A | 29 November 2018 |
|  |  |  |  | US | 2018316049 | A1 | 01 November 2018 |
|  |  |  |  | EP | 3396751 | A1 | 31 October 2018 |
|  |  |  |  | BR | 102018008016 | A2 | 21 November 2018 |
|  |  |  |  | KR | 20180121359 | A | 07 November 2018 |
|  |  |  |  | IN | 201814013315 | A | 02 November 2018 |
|  |  |  |  | EP | 3396751 | B1 | 30 October 2019 |
|  |  |  |  | KR | 102055548 | B1 | 13 December 2019 |
|  |  |  |  | JP | 6729481 | B2 | 22 July 2020 |
|  |  |  |  | CN | 108808111 | B | 17 August 2021 |
|  |  |  |  | US | 11302953 | B2 | 12 April 2022 |
| CN | 112186195 | A | 05 January 2021 | WO | 2021000546 | A1 | 07 January 2021 |
|  |  |  |  | EP | 3799171 | A1 | 31 March 2021 |
|  |  |  |  | US | 2021151769 | A1 | 20 May 2021 |
|  |  |  |  | EP | 3799171 | A4 | 03 November 2021 |
| CN | 113594615 | A | 02 November 2021 | None | | | |

Form PCT/ISA/210 (patent family annex) (January 2015)